(19) Europäisches Patentamt
European Patent Office
Office européen des brevets

(11) EP 2 833 553 B1

(12) **EUROPEAN PATENT SPECIFICATION**

(45) Date of publication and mention of the grant of the patent:
**31.03.2021 Bulletin 2021/13**

(51) Int Cl.:
***H03M 13/11*** *(2006.01)* ***H03M 13/00*** *(2006.01)*

(21) Application number: **13306098.8**

(22) Date of filing: **30.07.2013**

(54) **LDPC decoder**

LDPC-Decodierer

Décodeur LDPC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.02.2015 Bulletin 2015/06**

(73) Proprietor: **Alcatel Lucent**
**91620 Nozay (FR)**

(72) Inventor: **Schmalen, Laurent**
**70435 Stuttgart (DE)**

(74) Representative: **Novagraaf Technologies**
**Bâtiment O2**
**2, rue Sarah Bernhardt**
**CS90017**
**92665 Asnières-sur-Seine Cedex (FR)**

(56) References cited:
**US-A1- 2008 178 065**

- **NAM V T ET AL: "Iterative decoding of BDPSK modulated LDPC codes using two-symbol-interval observations", INFORMATION THEORY AND ITS APPLICATIONS, 2008. ISITA 2008. INTERNATIONAL SYMPOSIUM ON, IEEE, PISCATAWAY, NJ, USA, 7 December 2008 (2008-12-07), pages 1-5, XP031451224, ISBN: 978-1-4244-2068-1**
- **CUI Z ET AL: "Reduced-complexity column-layered decoding and implementation for LDPC codes", IET COMMUNICATIONS, THE INSTITUTION OF ENGINEERING AND TECHNOLOGY, MICHAEL FARADAY HOUSE, SIX HILLS WAY, STEVENAGE, HERTS. SG1 2AY, UK, vol. 5, no. 15, 14 October 2011 (2011-10-14), pages 2177-2186, XP006042662, ISSN: 1751-8628, DOI: 10.1049/IET-COM.2010.1002**
- **LIN JUN ET AL: "An improved min-sum based column-layered decoding algorithm for LDPC codes", SIGNAL PROCESSING SYSTEMS, 2009. SIPS 2009. IEEE WORKSHOP ON, IEEE, PISCATAWAY, NJ, USA, 7 October 2009 (2009-10-07), pages 238-242, XP031568761, ISBN: 978-1-4244-4335-2**
- **JIANRONG BAO ET AL: "Concatenated eIRA Codes for Tamed Frequency Modulation", IEEE INTERNATIONAL CONFERENCE ON COMMUNICATIONS, 2008 : ICC '08 ; 19 - 23 MAY 2008, BEIJING, CHINA, IEEE, PISCATAWAY, NJ, USA, 19 May 2008 (2008-05-19), pages 1886-1891, XP031265683, ISBN: 978-1-4244-2075-9**
- **LI MINGHUA ET AL: "A low-complexity joint noncoherent demodulation/decoding algorithm for nonbinary LDPC-coded differential modulation systems", 2013 IEEE CHINA SUMMIT AND INTERNATIONAL CONFERENCE ON SIGNAL AND INFORMATION PROCESSING, IEEE, 6 July 2013 (2013-07-06), pages 403-407, XP032501150, DOI: 10.1109/CHINASIP.2013.6625370 [retrieved on 2013-10-08]**

EP 2 833 553 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Embodiments of the present invention relate to communication systems and, more particularly to communication systems employing Low-Density Parity Check Codes (LPDC).

### Background

A Low-Density Parity Check Code (LPDC) is a linear error correcting code for transmitting a message over a noisy transmission channel, and may be constructed using a sparse bipartite graph whose vertices can be divided into two disjoint independent sets *U* and *V* such that every edge connects a vertex in *U* to one in *V*. An example of a bipartite graph used for LPDC codes is the so-called Tanner graph. In coding theory, Tanner graphs may also be used to construct longer codes from smaller ones. Both LPDC encoders and LPDC decoders may employ these graphs extensively.

An important application of LDPC codes is in optical or wireless communication systems. It is well-recognized that LDPC codes perform remarkably well assuming that a carrier phase is perfectly synchronized and coherent detection is performed. It should be noted however that, due to practical issues like complexity, acquisition time, sensitivity to tracking errors, and phase ambiguity, coherent detection may become expensive or infeasible in some cases. For example, in optical communications a signal received after carrier recovery may be affected by phase slips, with a probability depending on a nonlinear phase noise introduced by an optical transmission link, such as a fiber, for example. If the phase slip is not recovered correctly, error propagation may occur at the receiver and data following the phase slip may not be properly corrected by a decoder.

In such scenarios a technique of differential encoding becomes immediately relevant. Differential encoding admits simple non-coherent differential detection which solves phase ambiguity and requires only frequency synchronization (often more readily available than phase synchronization). Viewed from the coding perspective, performing differential encoding is essentially concatenating the original code with an accumulator, or, a recursive convolutional code.

When regarding iterative decoding of a Forward Error Correction (FEC) code, such as LDPC, and a differential code, the random phase slips on a transmission channel can be taken into account by an appropriately chosen clipping function (S-Function) which may be inserted in an iterative loop between the differential decoder and FEC decoder. The advantage of this solution is that a standard differential decoder with soft-output decoding can be utilized. Such a decoder may be commonly based on the trellis representation using the MAP/BCJR (MAP = Maximum A Posteriori; BCJR = Bahl, Cocke, Jelinek and Raviv) algorithm. The drawback of this solution is however that the Very-Large-Scale Integration (VLSI) implementation is complicated due to the presence of two different decoding domains. Thereby VLSI commonly denotes a process of creating integrated circuits by combining thousands of transistors into a single chip.

An LPDC decoder most commonly used in the field of optical communications with high-rate codes is the so-called row-layered decoder. This decoder operates on rows of a parity check matrix of the employed LDPC code and processes each row or groups of independent rows separately. However, this complicates the interaction with a differential trellis decoder, as different parts of the received code word correspond to a row of the parity check matrix. Furthermore, from a-posteriori values computed by the LPDC row-layered decoder, previous input values need to be subtracted before feeding them to the differential trellis decoder as updated a-priori information and then they need to be added in a next step before going back into the LDPC row-layered decoder. This leads to increased memory costs required for bypassing these input values in a digital circuit.

Hence, it is desirable to improve the interaction between LPDC decoders and differential decoders.

Jianrong Bao et al., "Concatenated eIRA Codes for Tamed Frequency Modulation" in IEEE INTERNATIONAL CONFERENCE ON COMMUNICATIONS (ICC 2008), pp.1886-1891, describes an iterative joint decoding interaction between a differential decoder and a LDPC decoder.

### Summary

It has been found that one possibility to overcome the above limitations is to combine so-called row-layered LPDC decoding with iterative differential decoding by employing a column-layered decoding scheme together with a differential decoding scheme. In such an implementation, the LPDC code's parity-check matrix may be processed column by column, which lends itself to a more natural interaction of the LDPC decoder and a differential trellis decoder. With such an implementation, the trellis decoder and the LDPC decoder can be realized as two concurrent entities.

Hence, according to a first aspect embodiments provide a decoder for iteratively decoding a received signal. Thereby the signal has been generated or obtained by encoding an LDPC code word with a differential code. That is to say, a transmitting entity may comprise a serial concatenation of an LDPC encoder and a differential encoder. According to embodiments the decoder correspondingly comprises a differential decoder stage which is operable or configured to provide extrinsic probability information on the LDPC code word based on the received (differentially encoded) signal and based on a-priori probability information on the received signal. According to some embodiments the differential decoder stage may be operable or configured to provide the extrinsic probability information based on a trellis-based soft-decision decoding rule of the received signal. Further, embodiments of the decoder comprise a column-layered LDPC decoder stage which is operable or configured to process columns of the employed LDPC code's parity check matrix based on the extrinsic probability information from the differential decoder stage to obtain updated a-priori probability information for the differential decoder stage. The updated a-priori probability information is used by the differential decoder stage to compute updated extrinsic probability information on the LDPC code word, which is used by the column-layered LDPC decoder stage in a subsequent decoding iteration until a termination criterion is fulfilled.

According to some embodiments the decoder serves for performing a corresponding method for iteratively decoding a received signal generated by encoding an LDPC code word with a (trellis based) differential code.

Embodiments of the decoder may for example be comprised by an optical communications device, such as an optical receiver, which may comprise further receiver circuitry, such as mixers, Analog-to-Digital Converters (ADCs), demodulators, outer decoders, analog and/or digital signal processors, etc. Consequently, the received (differentially encoded) signal may have been transmitted via an optical communication channel, such an optical fiber, for example. However, it will be appreciated by the skilled person that embodiments may also be beneficial for other than optical communication systems, such as wireless communication systems, for example.

As the LDPC codes used in optical communications are mainly high-rate LDPC codes with rates higher than 0.8 (overhead smaller than 25%), these LDPC codes are usually based on parity check matrices **H** of size $M$ (rows) x N (columns), with $M << N$. Hence, the number of operations the column-layered LDPC decoder stage needs to carry out scales with $N/M$ compared to a conventional row-layered LDPC decoder stage. Let this operational overhead factor be denoted as $O := N/M$ for subsequent reference. Although one column-layered decoder operation according to embodiments is less complex than a corresponding conventional row-layered decoder operation, this has large implications for a parallelized and pipelined VLSI implementation, resulting in substantial memory requirements.

Hence, according to an example, a novel LDPC code design allows to implement a column-layered LDPC decoding platform with decreased operational overhead factor $O' = O/2$, $O/3$, $O/4$, $O/5$, ... This may be achieved by designing a Quasi-Cyclic (QC) or a protograph LDPC code in such a way that its lifting matrix **A** and thus also the associated parity-check matrix **H** has (chunks of) neighboring entries, such that the column-layered LDPC decoder stage can easily process several neighboring columns of the lifted parity-check matrix **H** (or the lifting matrix **A)** with limited memory accesses.

Thereby the parity check matrix **H** is constructed from a lifting matrix **A** by replacing an entry of **A** with either an all-zero matrix of size $S \times S$ or a cyclically permuted identity matrix of size $S \times S$, depending on the considered entry of **A.** For example, if the entry of **A** corresponds to a predetermined value of e.g. -1 it may be replaced by an all-zero matrix of size $S \times S$ to construct the lifted parity check matrix **H.** The lifting matrix **A** is designed such that an entry $A_{i',j}$ of the $i'$-th column and the $j$-th row of the lifting matrix **A** is $x$ if an entry $A_{i,j}$ of the $i$-th column and the $j$-th row of the lifting matrix **A** is $x$, wherein $x$ denotes a predetermined value leading to void entries in the corresponding LDPC code's parity check matrix **(H),** and wherein $i=1,1+L,1+2L,....$ and $i'=i+1,i+2,...,i+L-1$, with $L$ being an integer. Instead of a cyclically permuted identity matrix also another permutation matrix can be chosen, thereby resulting in a code denoted "protograph code".

Some embodiments also provide a computer program having a program code for performing embodiments of the method, when the computer program is executed on a computer or a programmable hardware device.

Embodiments may help to decrease a VLSI implementation complexity of optical transport systems utilizing iterative differential decoding to avoid the differential loss. Embodiments may facilitate VLSI implementation and may largely reduce implementation complexity of an iterative differential decoder, especially in terms of memory consumption. One advantage is an improved interoperability between a differential decoder and an LDPC decoder.

## Brief description of the Figures

Some embodiments of apparatuses and/or methods will be described in the following by way of example only, and with reference to the accompanying figures, in which

Fig. 1 schematically illustrates a signal processing chain of an optical communication system;

Fig. 2 illustrates a block diagram of a conventional row-layered decoder with check node decoding operation;

Fig. 3 shows a detailed view of a row-layered decoder processing check node 5 of a code with $\mathcal{N}(5) = \{1; 5; 9; 13; 21\}$;

Fig. 4 illustrates row-layered decoding and scattered memory access to the variable node aposteriori memory;

Fig. 5 shows a simplified view of a row-layered decoder (row decoder) for quasi-cyclic LDPC codes for the first row of an example matrix;

Fig. 5a illustrates a pipelined implementation of the iterative differential decoding using trellis-based differential decoding;

Fig. 6 illustrates a schematic block diagram of a decoder according to an embodiment;

Fig. 7 illustrates a detailed block diagram of a decoder according to an embodiment being in a first iteration;

Fig. 8 illustrates a detailed block diagram of the decoder of Fig. 7 being in a subsequent iteration;

Fig. 8a illustrates a detailed block diagram of the variable node operation of the decoder of Fig. 7 being in an arbitrary iteration;

Fig. 9 illustrates a detailed block diagram of the decoder of Fig. 7 being in a final iteration;

Fig. 10 illustrates a variable node operation for a $d_v$=3 variable node for a quasi-cyclic code;

Fig. 11 illustrates a variable node operation for a $d_v$=3 variable node for a quasi-cyclic code;

Fig. 12 shows a modified variable node operation for a $d_v$=3 variable node;

Fig. 13 shows a variable node operation with min-sum operation wherein the check node memory is based on a sorted minima list;

Fig. 14 illustrates a variable node operation with min-sum operation wherein the check node memory is based on a simplified sorted minima list;

Fig. 15a illustrates a conventional quasi-cyclic LDPC code under column-layered decoding (dim(**H)** = 3000x25000);

Fig. 15b illustrates a group-column-layered decoded code with excess check node memory accesses;

Fig. 16a illustrates a proposed Multiple-Column code with L=2, reducing the number of visited variable node (groups) by two;

Fig. 16b shows a proposed Multiple-Column code with L=4, reducing the number of visited variable node (groups) by four;

Fig. 17 illustrates a proposed multiple column decoder for L=2 with concurrent decoding of two neighboring trellis segments;

Fig. 18 illustrates a variable node operation for a multiple column code with a $d_v$=2 variable node for a quasi-cyclic code, multiple column grouping factor L=2;

Fig. 18a illustrates an operation of a multi-column-layered decoder for an $L$=2 example matrix;

Fig. 19 shows a simplified multiple-column decoder for min-sum decoding, multiple column grouping factor $L$=2;

Fig. 20 shows a masked multiple-column code for L=4 with masked entries marked by circles;

Fig.20a shows an example for a decoder for a masked multiple-column code, multiple column grouping factor $L$=2;

Fig. 21 shows simulation results for $L$=1, 2, 4, for a code with $S$=300, $M$=3300, $N$=24000, i.e., of rate 0.8625 after 12 iterations with a fixed variable node degree profile with only degree 2 and degree 3 variable nodes (55% degree 2 and 45% degree 3); and

Fig 22 illustrates a convergence speed of a multiple-column code for L=1, 2, 4 and iterations required for achieving a target BER of 3.8e-3.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (*e.g.*, "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

**Fig. 1** illustrates a system overview, which will be used subsequently to further detail and explain some embodiments.

Fig. 1 shows a signal processing chain of a communication system 100, e.g. an optical communication system, which can also be provided by embodiments. The signal processing starts at the upper left corner of Fig. 1 with an outer encoder 102, which may, for example, correspond to a convolutional encoder, a Reed Solomon encoder, or a Turbo product encoder 102. The task of the outer encoder 102 is to add redundancy to an input information word, which may comprise digitized data. The output of the outer encoder 102 may then be input into an interleaver 104, which interleaves the data. The interleaving can be adapted to an error characteristic, which is introduced in a transmission channel 114 later on such that burst errors can be resolved by subsequent de-interleaving 124 to enable enhanced error correction at an outer decoder 126. In the exemplary communication system 100 the interleaved data may then be input into an LDPC encoder 106 to obtain (encoded) LPDC code words before being assigned to transmission symbols by a mapping entity 108. The transmission symbols may then be differentially encoded by a differential encoder 110 to prevent or limit the effect of phase slips, which may occur due to undetectable phase noise events in the subsequent transmission channel 114. Strictly speaking, the phase slips do not occur in the transmission channel as such but are due to phase noise events that cause a phase offset correction algorithm to make a wrong decision. As the phase noise correction algorithm is part of the digital signal processing chain that is now shown in Fig. 1 and that can be considered as being either part of the transmission channel 114 or as being part of the demodulation 116. Differentially encoded data symbols may be derived, using a linear feedback shift register which contains a delay element. The transfer function of the linear feedback shift register performing the differential encoding rule is given in the z-domain as $H(z) = 1/(1-z^{-1})$. In the BPSK case, the differential encoder 110 can be represented as a simple accumulator computing $y_i = y_{i-1} \oplus x_i$, where "$\oplus$" denotes the modulo-2 addition or the eXclusive OR (XOR) operation, respectively. The differentially encoded transmission symbols are then modulated by modulator 112 and transmitted through the transmission channel 114. Note that the blocks 102 to 112 make up a transmitter of the communication system 100. According to embodiments this can be an optical transmitter.

The modulation 112 may comprise a conversion from a base band, which can be complex, to a transmission band as well as a conversion from a digital/electrical to an optical signal. In the present example an optical conversion and thus an optical transmission channel 114 is assumed. In a transmission channel, e.g. an optical, a wireless, a wireline or a powerline transmission channel, phase slips can occur due to the inability of a receiver to handle large phase noise, i.e. the phase may jump or suddenly change by a certain angle. This angle may correspond to 180° or $\pi$ in a BPSK case; it may correspond predominantly to 90° or $\pi/2$ in the QPSK case. Such a phase slip may result in erroneous symbols being detected subsequently. The differential coding 110 limits the effect of a phase slip to the symbol, which is detected subsequent to the phase slip, as the difference to the previous symbol only is affected by the phase slip. However, since the difference to the next symbol is not affected by the phase slip (assuming only a single phase slip to occur), the differential encoding limits the effect of a phase slip. As the phenomenon of phase slips is well known in the art further details will be omitted not to obscure the principles of embodiments.

At the receiver the received differentially encoded data symbols, i.e. the differentially encoded the LPDC code words, may be demodulated 116, where the demodulation 116 may include optical/electrical conversion and conversion from the transmission band to the complex base band. Fig. 1 illustrates a processing path between the demodulation 116 and a subsequent de-interleaver 124 involving a differential decoder 118, a clipping function 120 and an LDPC decoder 122. Following the processing path, the base band symbols may be differentially decoded 118, which may result in soft information, i.e. information on estimated symbols or bits and reliability information thereon, which can, for example, be expressed in terms of likelihood values or log-likelihood values. This soft information from the differential decoder 118 may also be denoted as extrinsic probability information in the following. In the example shown in Fig. 1 a clipping function 120 may be applied to the output of the differential encoder. The clipping function 120 limits the likelihood values (extrinsic probability information) to enable a better decoding performance of the subsequent LDPC decoder 122. The performance of the LDPC decoder 122 can be improved by the limitation as an upper limit of the likelihood values can be assumed based on a known occurrence or probability of occurrence of a phase slip. For example, the probability of a phase slip for a given optical channel may be in a range around $10^{-3}$. Hence, all likelihood values can be limited to $\log((1-10^{-3})/10^{-3}) \approx 6.91$, as this is the highest certainty that can be achieved. In other words, a residual error rate of $10^{-3}$ is known and considered by using an according the clipping function 120. This is only a simplified view. The clipping function can be a pure clipping function that saturates all values above a certain threshold to that value or it can be a smooth function given by an equation f(x) = log(((1-Ps)*exp(x) + Ps)/(Ps*exp(x) + (1-Ps))), wherein Ps denotes the probability of a phase slip.

The clipped output of the clipping function 120 may then be input into the LDPC decoder 122, which will be explained in more detail below. The LDPC decoder 122 may then determine updated likelihood values, which may be fed back to the clipping function 120 and from there to the differential decoder 118 as priori probability information for a next iteration of differential decoder 118, which is indicated by the arrows between the differential decoder 118, the clipping function 120, and the LDPC decoder 122. The circular shaped arrows indicate that a number of iterations may be carried out, wherein the likelihood values are updated by one of the decoders 118, 122 and clipped in between by the clipping function 120. The decoding iteration may be terminated by a parity check criterion. The output from the LDPC decoder 122 may then be de-interleaved by de-interleaver 124 before being provided to the outer decoder 126 for outer decoding in line with the above described outer encoding 102.

For a better understanding of embodiments a short introduction to LDPC codes and some related decoding algorithms will be provided in the following.

An LDPC code is defined by a sparse binary parity check matrix **H** of dimension $M \times N$, where $N$ is the LDPC code word length (in bits) of the code and $M$ denotes the number of parity bits. Usually, the number of information bits equals $M-N$. The design rate of the code amounts to $r = (N-M)/N$. The overhead of the code is defined as OH = $1/r - 1 = M/(N-M)$. Sparse means that the number of Is in **H** is small compared to the number of zero entries. Practical LDPC codes usually have a fraction of Is that is below 1% by several orders of magnitude.

We start by introducing some notation and terminology related to LDPC codes. Each column of the parity check matrix **H** corresponds to one bit of the FEC frame or LPDC code word. As LDPC codes can also be represented in a graphical structure called Tanner graph (which we will not introduce here), the columns of **H** and thus the FEC frame (LPDC code word) bits are sometimes also called variable nodes, referring to the graph-theoretic representation. Similarly, each row of **H** corresponds to a parity check equation and ideally defines a parity bit (if **H** has full rank). Owing to the Tanner graph representation, the rows of **H** are associated to so-called check nodes.

In order to describe an LDPC decoder we introduce some additional notation. First, we denote by **x** the vector of $K = N-M$ information bits. The single elements of **x** are denoted by $x_i$, i.e., $\mathbf{x} = (x_1, x_2, ..., x_i, ..., x_K)^T$. After encoding with LDPC encoder 106, the LDPC code word $\mathbf{y} = (y_1, y_2, ..., y_N)^T$ of length $N$ results. We denote by $y_i$ the single bits of the code word **y.** The LDPC code is said to be systematic if the information vector **x** is included in the code word, e.g., if $\mathbf{y} = (x_1,..., x_K, p_1, ... p_M)^T$, with $\mathbf{p} = (p_1, ...,p_M)^T$ denoting the vector of $M$ parity bits. Furthermore, let the set $\mathcal{N}(m)$ denote the positions of the Is in the $m$'th row of **H,** i.e., $\mathcal{N}(m) = \{i : H_{m,i} = 1\}$. A binary vector **y** is a code word of the code defined by **H** if $\mathbf{Hy} = \mathbf{0}$, with the additions defined over the binary field (addition modulo-2, or XOR, respectively). The set of code words is thus defined to be the null space of **H.** This signifies that the product of each row of **H** and **y** must be zero, or $\sum_{j \in \mathcal{N}(m)} y_j = 0,$ for all $m$ with $1 \leq m \leq M$.

Let us illustrate the concept of LDPC codes by a "toy" example. This example defines the parity check matrix **H** of two concatenated (4, 5) single parity check codes, separated by a 4×5 block-interleaver. The exemplary parity check matrix **H** of dimension 9×25 is given by

$$\mathbf{H}=\begin{pmatrix}
1&1&1&1&&&&&&&&&&&&&1&&&&&&&& \\
&&&&1&1&1&1&&&&&&&&&&1&&&&&&& \\
&&&&&&&&1&1&1&1&&&&&&&1&&&&&& \\
&&&&&&&&&&&&1&1&1&1&&&&1&&&&& \\
1&&&&1&&&&1&&&&1&&&&&&&&1&&&& \\
&1&&&&1&&&&1&&&&1&&&&&&&&1&&& \\
&&1&&&&1&&&&1&&&&1&&&&&&&&1&& \\
&&&1&&&&1&&&&1&&&&1&&&&&&&&1& \\
&&&&&&&&&&&&&&&&1&1&1&1&&&&&1
\end{pmatrix}.$$

Note that for simplicity reasons only the Is are illustrated in the parity check matrix above. Thus, $M$ = 9, $N$ = 25, and the code has an overhead of 56% (given by $M/(N-M)$) or a rate of $r$ = 0.64, equivalently. We have $\mathcal{N}(1) = \{1; 2; 3; 4; 17\}$, $\mathcal{N}(2) = \{5; 6; 7; 8; 18\}$, $\mathcal{N}(3) = \{9; 10; 11; 12; 19\}$, $\mathcal{N}(4) = \{13; 14; 15; 16; 20\}$, $\mathcal{N}(5) = \{1; 5; 9; 13; 21\}$, $\mathcal{N}(6) = \{2; 6; 10; 14; 22\}$, $\mathcal{N}(7) = \{3; 7; 11; 15; 23\}$, $\mathcal{N}(8) = \{4; 8; 12; 16; 24\}$, $\mathcal{N}(9) = \{17; 18; 19; 20; 25\}$. This means for instance that we have (using the first row of **H)** $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One of the most common decoding algorithms for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we only focus on the latter in this specification.

In the context of coherent detection, we can usually assume an equivalent Additive White Gaussian Noise (AWGN) channel model for the transmission channel 114. This assumption is justified by the central limit theorem which applies due to the extensive use of filtering in inner Digital Signal Processing (DSP) stages of the transmitter and/or receiver. If we denote by $y_i$ (i = 1, ..., $N$) the single bits of an LDPC code word y as defined above, then the received values at the input of the LDPC decoder 122 after differential decoding 118 amount to $z_i = y_i + n_i$, with $n_i$ (i = 1, ..., $N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i)=\log\left(\frac{p(z_i \mid y_i=0)}{p(z_i \mid y_i=1)}\right) \tag{1}$$

with $p(z_i \mid y_i=k)=\exp\left(-(z_i-(1-2k))^2/(2\sigma^2)\right)/\sqrt{2\pi\sigma^2}$ denoting the probability density function (pdf) of the received sample $z_i$ under AWGN assumption conditioned on the transmitted bit $y_i$ and with bipolar signaling ($y_i$=0 → +1, $y_i$=1→ -1). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

In the following, we describe a conventional row-layered decoding algorithm, as introduced in D. E. Hocevar, "A Reduced Complexity Decoder Architecture via Layered Decoding of LDPC Codes," in Proc. IEEE Workshop on Signal Processing Systems (SIPS), 2004. Here, the LDPC decoder continuously updates the received LLR values with the goal to compute LLRs that approximate the Maximum A Posteriori (MAP) values. The received vector of LLRs z is therefore copied to a memory $\hat{z}$ of size $N$, which is continuously updated. The decoding operation in the row-layered decoder comprises three steps, where a) the first step prepares the input data, b) the second step performs the computation of new extrinsic data and c) the final step updates the LLR memory. The row-layered LDPC decoder carries out the three steps sequentially for each row of the parity check matrix **H.** After all rows have been considered, a single decoding iteration has been carried out. The decoder usually carries out several iterations, where the number depends on the available resources.

In the following, we describe the aforementioned three steps for a single row $m$ of **H.** The first step a) comprises computing $\mathrm{card}(\mathcal{N}(m)) = d_c$ (card = cardinality) temporary values $t_{m,i}$, with

$$t_{m,i} = \hat{z}_i - e_{m,i}^{(l)} \qquad \text{for all } i \in \mathcal{N}(m) \tag{2}$$

for all non-zero entries (indexed by $i$) of the m'th row of **H.** The superscript ($l$) denotes the iteration counter, i.e., the operations are carried out in the $l$-th iteration of the row-layered decoding procedure. The value $e_{m,i}$ is the (stored) extrinsic memory for row $m$ and variable $\hat{z}_i$. At the beginning of the decoding of a single frame (code word), all $e_{m,j}$ are initialized by zero (i.e., $e_{m,i}^{(1)} = 0$) and then continuously updated. Note that in total only $\sum_m \mathrm{card}(\mathcal{N}(m))$ memory locations are required for storing the $e_{m,j}$. If the code is check-regular, $\sum_m \mathrm{card}(\mathcal{N}(m)) = Md_c$. In the second step, the extrinsic memory for the subsequent iteration ($l$+1) is updated using the $t_{m,i}$ according to

$$\begin{aligned} e_{m,i}^{(l+1)} &= 2\cdot\tanh^{-1}\left(\prod_{j\in\mathcal{N}(m)\setminus\{i\}} \tanh\left(\frac{t_{m,j}}{2}\right)\right) \qquad \text{for all } i \in \mathcal{N}(m) \\ &= \left[\prod_{j\in\mathcal{N}(m)\setminus\{i\}} \mathrm{sign}(t_{m,j})\right]\cdot\phi\left(\sum_{j\in\mathcal{N}(m)\setminus\{i\}} \phi(|t_{m,j}|)\right), \quad \text{with } \phi(\tau) = -\log\left(\tanh\left(\frac{\tau}{2}\right)\right) = \log\left(\frac{e^\tau+1}{e^\tau-1}\right) \end{aligned} \tag{3}$$

where the second expression may be more suitable for practical implementations, as the multiplication is replaced by an addition and instead of two functions tanh(·) / $\tanh^{-1}$(·), only a single function $\phi(\cdot)$ needs to be implemented (or approximated by a look-up table). The product (or the sum) of equation (3) is carried out over all entries in $\mathcal{N}(m)$ except the one under consideration $i$. This is indicated by the notation $\mathcal{N}(m) \setminus \{i\}$. For instance, in the above example, where $\mathcal{N}(5) = \{1; 5; 9; 13; 21\}$, $e_{5,13}^{(l+1)}$ may be computed as

$$\begin{aligned} e_{5,13}^{(l+1)} &= 2\cdot\tanh^{-1}\left(\prod_{j\in\mathcal{N}(5)\setminus\{13\}} \tanh\left(\frac{t_{m,j}}{2}\right)\right) = 2\cdot\tanh^{-1}\left(\prod_{j\in\{1;5;9;21\}} \tanh\left(\frac{t_{m,j}}{2}\right)\right) \\ &= 2\cdot\tanh^{-1}\left(\tanh\left(\frac{t_{5,1}}{2}\right)\tanh\left(\frac{t_{5,5}}{2}\right)\tanh\left(\frac{t_{5,9}}{2}\right)\tanh\left(\frac{t_{5,21}}{2}\right)\right). \end{aligned} \tag{4}$$

The derivation of equation (4) for the extrinsic update is beyond the scope of this specification. Usually, if high LDPC decoder throughputs shall be achieved, the computation of $e_{m,i}$ should be further simplified. An often employed simplification of the log-domain equation (3), which we will consider in the following, is the so-called min-sum approximation which leads to

$$e_{m,i}^{(l+1)} = \left[\prod_{j\in\mathcal{N}(m)\setminus\{i\}} \mathrm{sign}(t_{k,j})\right] \min_{j\in\mathcal{N}(m)\setminus\{i\}} |t_{m,j}| \qquad \text{for all } i \in \mathcal{N}(m). \tag{5}$$

As this second step b) computes the output of the parity check node *m* of the check node in the graphical representation of LDPC codes, it is frequently denoted by check node operation.

Finally, in the last step c), the LLR memory is updated according to

$$\hat{z}_i = t_{m,i} + e_{m,i}^{(l+1)} \qquad \text{for all } i \in \mathcal{N}(m) \tag{6}$$

and the LDPC decoder continues with decoding row $m$+1 or, if $m = M$, restarts at $m$ = 1 (next iteration). **Fig. 2** shows the simplified block diagram 200 of the check node decoding operation for computing $e_{m,i}^{(l+1)}$. has been explained before, the check node operation 202 may be realized by equations (3) (log-domain) or (5) (min-sum domain).

The update step can be further simplified in actual implementations. Let $\mu_m^{[1]} = \min_{j \in \mathcal{N}(m)} |t_{m,j}|$ be the first minimum of the absolute value of all involved incoming messages $t_{m,j}$ at row $m$ and let $i_m^{[1]} = \arg \min_{j \in \mathcal{N}(m)} |t_{m,j}|$ be the position (i.e., the index) of this first minimum. Let furthermore $\mu_m^{[2]} = \min_{j \in \mathcal{N}(m) \setminus \{i_m^{[1]}\}} |t_{m,j}|$ be the second minimum (larger than the first minimum) of all incoming messages at row $m$. We further define $s_m = \prod_{j \in \mathcal{N}(m)} \text{sign}(t_{m,j})$. .The output message can then be computed by

$$e_{m,i}^{(l+1)} = s_m \cdot \text{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases} . \tag{7}$$

Thus, the main burden for implementing the check node operation 202 for computing $e_{m,i}^{(l+1)}$ consists in finding the first and second minimum of the incoming messages together with the position of the first minimum. The memory requirements of this algorithm are $N$ memory cells for storing the (continuously updated) a-posteriori values $\hat{z}_i$. Additionally, the storing requirements of the extrinsic memory $e_{m,i}$ 204 amount to the total number of Is in **H,** however, due to the simplified implementation using the minimum approximation, the extrinsic memory 204 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm is only an approximation to the full belief-propagation expression of equation (3), numerous attempts have been made to improve the performance of the min-sum algorithm. Two notable improvements are the normalized min-sum algorithm and the offset min-sum algorithm, see J. Chen, A. Dholakia, E. Eleftheriou, M. P. C. Fossorier, and X.-Y. Hu, "Reduced-Complexity Decoding of LDPC Codes," IEEE Transactions on Communications, vol. 53, no. 8, pp. 1288-1299, Aug 2005. The update rule of the offset min-sum algorithm reads

$$e_{m,i}^{(l+1)} = s_m \cdot \text{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \tag{8}$$

where the variable $\beta$ can either be constant and determined offline or be updated during decoding according to a predefined rule.

The simplified row-layered decoder block diagram 300, which can be derived from Fig. 2 in a straight forward way, is shown in **Fig. 3.** Thereby Fig. 3 exemplarily illustrates the check node operation for all entries in $\mathcal{N}(m)$, for

example, $\mathcal{N}(5) = \{1; 5; 9; 13; 21\}$.

In order to recover the performance loss due to differential encoding, the LDPC decoder 122 can iteratively invoke the soft-input soft-output differential detector 118 as e.g. described in EP 2 538 596 A1. If a row-layered LDPC decoder is used, this has some implications on the architecture. The differential detector 118 may be implemented using the BCJR algorithm operating on a trellis diagram, see L. R. Bahl, J. Cocke, F. Jelinek, and J. Raviv, "Optimal Decoding of Linear Codes for minimizing symbol error rate", IEEE Transactions on Information Theory, vol. IT-20(2), pp.284-287, March 1974. In the remainder of this specification we employ the terms "trellis", "trellis decoder", "differential detector" synonymously. We can describe the trellis by a function y = $f_T$(s,a), with s denoting the vector of received modulation symbols from demodulator 116 and a denoting a-priori knowledge from the LDPC/FEC decoder 118, 122. The trellis decoder 118 delivers extrinsic information at its output (see J. Hagenauer, E. Offer, L. Papke, "Iterative Decoding of Binary Block and Convolutional Codes", IEEE Trans. Inform. Theory, vol. 42, no. 2, March 1996).

Before first invoking the LDPC decoder 122, the differential detector 118 first needs to prepare the data and fill the LDPC decoder's a-posteriori memory $\hat{z}_i\ (i \in \mathcal{N}(m))$. This may initially be done by executing the trellis decoder 118 without a-priori knowledge: $\hat{z}_i = f_T(S,0)_i$ and by storing these initial values in a bypass memory 206, i.e., $b_i^{(1)} = \hat{z}_i = f_T(\mathbf{s},0)_i$. Then the LDPC decoder 122 is executed and the LDPC decoder's a-posteriori memory $\hat{z}_i$ is updated several times during the execution of the LDPC decoder 122. This is illustrated by the block diagram of Fig. 5a. Note that in the initial (first) iteration $e_{m,i}^{(1)} = 0$, i.e., the extrinsic memory 204 is initialized to zero.

After executing the LDPC decoder 122, we now have updated values $\hat{z}_i$ in the LDPC decoder's a-posteriori memory. The input to the subsequent differential decoder stage 118 is obtained by subtracting the bypass memory $b_i$ from the a-posteriori values $\hat{z}_i$. The next trellis output may be computed according to

$$b_i^{(2)} = f_T(\mathbf{s}, \hat{z}_i - b_i^{(1)})_i, \tag{9}$$

or more generally

$$b_i^{(l+1)} = f_T(\mathbf{s}, \hat{z}_i - b_i^{(l)})_i, \tag{10}$$

where b denotes the extrinsic information computed by the trellis decoder 118 (see J. Hagenauer, E. Offer, L. Papke, "Iterative Decoding of Binary Block and Convolutional Codes", IEEE Trans. Inform. Theory, vol. 42, no. 2, March 1996). In order to get the updated a-posteriori value $\hat{z}_i'$, we need to add the input of the trellis decoder 118 to its output, i.e., we get the updated a-posteriori value according to

$$\hat{z}_i' = \hat{z}_i - b_i^{(l)} + b_i^{(l+1)} = \hat{z}_i - b_i^{(l)} + f_T(\hat{z}_i - b_i^{(l)})_i. \tag{11}$$

Generally, in the case of LDPC codes, easy decoding algorithms exist and in contrast to classical channel coding, the challenge is not to find a good decoder for a given code, but to find a good code given the decoding algorithm. Most LDPC codes that are implemented today are so-called Quasi-Cyclic (QC) LDPC codes. They have a parity check matrix **H** with a structure that allows for inherent parallelization of the decoder and leads to an efficient encoder realization. Almost all LDPC codes utilized in practice belong to the class of QC LDPC codes.

QC-LDPC codes may be constructed using a so-called lifting matrix **A.** The parity check matrix **H** is constructed from the lifting matrix **A** by replacing each element of **A** with either an all-zero matrix of size $S \times S$ or a permutation matrix, e.g. a cyclically permuted identity matrix, of size $S \times S$, or a superposition of multiple permutation matrices of size $S \times S$. We adhere to the following notation: S denotes the lifting factor, i.e., the size of the all-zero or cyclically shifted identity matrix. If the entry of **A** at row *m* and column *i*, e.g., $A_{m,i} = -1$, then the all-zero matrix of size $S \times S$ is used, and if $A_{m,i} \geq 0$, $A_{m,i}$ denotes how many cyclic right shifts of the identity matrix are performed. If dim(**H**) = $M \times N$, then dim(**A**) = $M' \times N'$, with $M'=M/S$ and $N'=N/S$. We furthermore define the set $\mathcal{N}_{\mathbf{A}}(m)$ to denote the positions of the non "-1" entries (or any other entry denoting a void replacement) in the m'th row of **A,** i.e., $\mathcal{N}_{\mathbf{A}}(m) = \{i : A_{m,i} \neq -1\}.$

Let us illustrate the construction of QC-LDPC codes by a small (artificial) example with a lifting matrix of size dim(**A**) = 3×5 and a lifting factor of $S$ = 5 (leading to dim**(H)** = S·dim(A) = 15×25, this corresponds to a code of design rate r = 0.4, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = \left(\begin{array}{ccccc|ccccc|ccccc|ccccc|ccccc}
&&&& & 1&&&& & &1&&& & &1&&& & &&1&& \\
&&&& & &1&&& & &&1&& & &&1&& & &&&1& \\
&&&& & &&1&& & &&&1& & &&&1& & &&&&1 \\
&&&& & &&&1& & &&&&1 & &&&&1 & 1&&&& \\
&&&& & &&&&1 & 1&&&& & 1&&&& & &1&&& \\
\hline
&&1&& & &&&& & &&&&1 & &&1&& & &1&&& \\
&&&1& & &&&& & 1&&&& & &&&1& & &&1&& \\
&&&&1 & &&&& & &1&&& & &&&&1 & &&&1& \\
1&&&& & &&&& & &&1&& & 1&&&& & &&&&1 \\
&1&&& & &&&& & &&&1& & &1&&& & 1&&&& \\
\hline
&1&&& & &&&1& & &&&& & &&&1& & &1&&& \\
&&1&& & &&&&1 & &&&& & &&&&1 & &&1&& \\
&&&1& & 1&&&& & &&&& & 1&&&& & &&&1& \\
&&&&1 & &1&&& & &&&& & &1&&& & &&&&1 \\
1&&&& & &&1&& & &&&& & &&1&& & 1&&&&
\end{array}\right) \quad (12)$$

Note that for the sake of clarity again only the 1s are show in the description of **H.** Generally the value S corresponds to the parallelism that can be implemented in the QC-LDPC decoder 122.

**Fig. 4** illustrates an example of such a quasi-cyclic parity check matrix **H** (reference numeral 400) of size 3000x25200 ($M$ = 3000, $N$ = 25200) resulting from a lifting matrix **A** of size dim(**A**) = 10x84 with a lifting factor $S$ = 300. Note that also in this case, **A** is sparse, i.e., most entries of **A** are e.g. -1, leading to zero entries for **H.** Note that in Fig. 4 the Is of **H** are shown as small points. Due to the cyclic structure of the matrix **H,** these show up as diagonal lines in Fig.4.

The implications of the quasi-cyclic (QC) code construction on the row-layered LDPC decoder is shown in **Fig. 5.** Due to the cyclic structure of **H,** the row layered LDPC decoder 500 can now process always S rows **of H** in parallel as these computations are independent. This parallelism is necessary to be able to operate at decoding speeds of 100Gbit/s and above. Instead of decoding each row of **H,** the row-layered decoder 500 for QC LDPC codes does now decode each row of the lifting matrix **A.**

The decoding circuitry set up for decoding the first row of **A** of the example above is shown in Fig. 5. Decoding the first row of **A** corresponds to decoding the first $S$ = 5 rows of **H.** Note that $S$ = 5 in this example, such that $S$ = 5 check node decoding circuits 200-1 to 200-5 can be deployed in parallel. Note that the first row of **A** contains only 4 non-void entries (as does any other row), which means that each of the first 5 rows of **H** contains only 4 ones. In the left part of the circuit 500 shown in Fig. 5, the memory fetching circuits 510 each retrieve $S$ = 5 neighboring values $\hat{z}_i$ of the a-posteriori memory. For example, the uppermost fetching circuit 510-1 retrieves the vector $\hat{z}_{6:10} = (\hat{z}_6\ \hat{z}_7\ \hat{z}_8\ \hat{z}_9\ \hat{z}_{10})$ where the notation "6:10" denotes the entries 6 to 10.These are then processed by the shifting circuit 515-1 (which can be realized using a barrel shifter) to account for the cyclic shifting nature of **H.** If we consider the bottom fetch circuit 510-4 which retrieves $\hat{z}_{21:25} = (\hat{z}_{21}\ \hat{z}_{22}\ \hat{z}_{23}\ \hat{z}_{24}\ \hat{z}_{25})$, the corresponding entry of **A** is $A_{1,5}$ = 2, which means that the shifter 515-4 is configured such that it performs a (cyclic) left-shift by "2" and the output of the shifter 515-4 is the vector $(\hat{z}_{23}\ \hat{z}_{24}\ \hat{z}_{25}\ \hat{z}_{21}\ \hat{z}_{22})$. The individual outputs of the shifters 515 are then fed to check node operations 202 as described above, and the outputs of the S = 5 parallel check node circuits 200-$s$ ($s$ = 1 ... $S$) are gathered and then fed to a bank of four inverse shifters 525, that are configured using the same values but perform cyclic right-shifts of the S values at their inputs. These are then stored again in the a-posteriori memory 510.

The idea of a column-layered LDPC decoder is to exchange the role of rows and columns in the LDPC decoder 122. The role of the LLR a-posteriori memory 510, which served as interface to the trellis differential decoder 118 in the aforementioned row-layered LDPC decoding algorithm, may now be taken over by the so-called check node memory.

The idea of a column-layered decoder has been presented in Z. Cui, Z. Wang, and X. Zhang, "Reduced-Complexity Column-Layered Decoding and Implementation for LDPC Codes," IET Communications, where an efficient hardware implementation was presented. The system in Z. Cui, Z. Wang, and X. Zhang, "Reduced-Complexity Column-Layered Decoding and Implementation for LDPC Codes," IET Communications only deals with the pure LDPC decoding hardware architecture and does not contain any demodulator or differential decoder 118 in the iterative loop. In addition to that, M. Li, C. A. Nour, C. Jégo, J. Yang, and C. Douillard, "A shuffled iterative bit-interleaved coded modulation receiver for the DVB-T2 standard: design, implementation and FPGA proto-typing", IEEE Workshop on Signal Processing Systems (SIPS), Oct. 2011 show how the hardware implementation can be extended to include the soft-input soft-output demodulator of the modulation format used in Digital Video Broadcasting - Second Generation Terrestrial (DVB-T2). They realize a BICM-ID decoder (Bit-Interleaved Coded Modulation with Iterative Decoding) system with the column-layered decoding.

According to embodiments of the present invention the soft-input soft-output demodulator (which generates extrinsic probabilities of the single bits associated to a modulation symbol based on the a-priori probabilities computed by the FEC decoder) is replaced by a trellis-based differential decoder 118. Hence, embodiments provide a decoder 118, 122 for iteratively decoding a received signal s generated by encoding an LDPC code word with a differential code. Thereby the decoder comprises a differential decoder 118 which is operable to provide extrinsic probability information z on the LDPC code word based on the received signal s (from the demodulator 116) and based on a-priori probability information on the received signal. Further, the decoder comprises a column-layered LDPC decoder 122 which is operable or configured to process columns of the LDPC code's parity check matrix **H** (or its lifting matrix **A)** based on the extrinsic probability information z from the differential decoder stage 118 to obtain updated a-priori probability information for a next iteration of the differential decoder 118.

As has been explained before, the differential decoder 118 may be operable or configured to provide the extrinsic probability information based on a trellis-based decoding rule. That is to say, the differential decoder 118 may implement a conventional trellis based soft-output decoding algorithm, such as the soft output Viterbi algorithm (SOVA) or the BCJR algorithm, which is an algorithm for Maximum A Posteriori (MAP) decoding of error correcting codes defined on trellises (principally convolutional codes). The algorithm is named after its inventors: Bahl, Cocke, Jelinek and Raviv.

In the following, we describe in a step-by-step procedure how an embodiment of the column-layered LDPC decoder 122 is working. We first start with the most general log-domain check node operations given in equation (3) and later show how the decoder 118, 122 can be further adapted to an even more efficient operation. For the sake of explanation only, we resort to an embodiment using an implementation with log-domain tanh/tanh$^{-1}$ operations. However, note that the described tanh/tanh$^{-1}$ operations may well be approximated by computationally less expensive operations in other embodiments.

According to some embodiments the column-layered LDPC decoder 122 may comprise a check node memory having *M* check node memory cells, where *M* denotes the number of rows of the LDPC code's parity check matrix **H.** In a first initialization act of a column-layered LDPC decoding method, said check node memory may be initialized. First, the initialization act may compute (using the initial input values $\hat{z}$ at the LDPC decoder 122, i.e., the initial extrinsic output of the trellis decoder 118),

$$c_m = \prod_{j\in\mathcal{N}(m)} \tanh\left(\frac{\hat{z}_j}{2}\right) \qquad \text{for all } m \in [1;M] \ . \tag{13}$$

The values $c_m$ may be saved in the LDPC decoder's check node memory.

**Fig. 6** illustrates an example of a decoder 600 according to an embodiment. The decoder 600 comprises a differential decoder stage 118 and a column-layered LDPC decoder stage 122 interacting with each other in various decoding iterations. The column-layered LDPC decoder stage 122 comprises a check node memory 602, an extrinsic memory 604, and a block 606 for carrying out column-layered variable node operations that will we explained in the following.

Turning to **Fig. 7,** which illustrates more details of the exemplary decoder 600, above equation (13) may be carried out in a block 702 denoted "Initial CN computation". Thereby equation (13) may be performed for each of the *M* rows of the parity check matrix **H.** In principle, all *M* operations can be carried out in parallel if this is allowed by the memory fetching and storing architecture. If QC-LDPC codes are used, the processing can be performed by considering all the $M' = M/S$ rows in the lifting matrix **A** and *S* computations can be carried out in parallel for each lifting matrix row. Note that this computation act (corresponding to equation (13)) only needs to be done once in the beginning of decoding. Following this initial act, the actual iterative decoding procedure between differential decoder 118 and LDPC decoder 122 begins. The check node memory 602 can be seen as an equivalent to the a-posteriori memory $\hat{z}$ of the row-layered decoder, which has been described before.

In the first initialization act of a column-layered LDPC decoding method also memory cells of the extrinsic memory 604 (which now has a slightly different role as above) may be initialized to the values

$$e_{n,m}^{(l)} = \tanh\left(\frac{\hat{z}_n}{2}\right) \text{ for all } n = 1 \ldots N, \tag{14}$$

or an approximation thereof, wherein $e_{n,m}^{(l)}$ corresponds to a cell of the extrinsic memory corresponding to an n-th column and an *m*-th row of the LDPC code's parity check matrix **H.** $\hat{z}_n$ denotes the *n*-th entry of the extrinsic probability information 608 coming from the differential decoder 118. The operation according to equation (14) may be performed by block 704 in Fig. 7. Note that the computation of equation (14) can also be carried out in the logarithmic domain where the product becomes a summation (which can have advantageous properties). Hence, the skilled person will recognize that computations in the tanh/tanh$^{-1}$ domain may as well be carried out in the logarithmic domain, and that the operations in the different domains correspond to each other. This also holds for subsequent operations.

We now introduce some additional nomenclature to simplify the description of the decoder 600. Let the set $\mathcal{M}(n)$ denote the positions of the Is in the *n*-th column of **H,** i.e., $\mathcal{M}(n) = \{j : H_{j,n} = 1\}$. Additionally, we denote by the set $\mathcal{M}_{\mathbf{A}}(n)$ the positions of the non "-1" entries (or any other entry denoting void positions) in the *n*-th column of A, i.e., $\mathcal{M}_{\mathbf{A}}(n) = \{j : A_{j,n} \neq -1\}$. The column-layered decoder stage 122 may now process each column *m* of the parity check matrix H (or a single column of A corresponding to *S* independent columns of H, if a quasi-cyclic code is employed) and may compute first temporary information according to

$$t_{n,i} = \frac{c_i}{e_{n,i}^{(l)}} \qquad \text{for all } i \in \mathcal{M}(n) \tag{15}$$

or an approximation thereof. The equation (15) may be realized by blocks 706 in Fig. 7.

An a-posteriori output v of the LDPC decoder 122 may now be computed according to

$$v_n = \hat{z}_n + 2 \sum_{i \in \mathcal{M}(n)} \tanh^{-1}(t_{n,i}) \tag{16}$$

or an approximation thereof. The equation (16) may be realized by blocks 708 in Fig. 7.

An updated a-priori probability information 610 to the trellis decoder 118 can be obtained by subtracting the old extrinsic probability information 608 $\hat{z}_n$, i.e., $u_n = v_n - \hat{z}_n$ (see reference numeral 712 in Fig. 7).

We can now invoke the trellis detector 118, which computes updated extrinsic probability information $\hat{z}_n' = fT(s,u_n)$ 608 which can then be used in the subsequent iteration (*l*+1). Updated extrinsic values and updated CN memory values may be computed according to

$$e_{n,i}^{(l+1)} = \tanh\left(\frac{v_n - 2\tanh^{-1}(t_{n,i})}{2}\right), \qquad c_i = e_{n,i} \cdot t_{n,i} \tag{17}$$

or an approximation thereof. Equation (17) can be carried out by blocks 714 and 716 in Fig. 7. Following this, the next column of **H** can be decoded. Equations (15) to (17) may also be denoted as variable node operations, which may be performed by block 606 of Fig. 6. That is to say, Fig. 7 is a more detailed view of Fig. 6.

A detailed implementation using the above equations is also shown in **Fig. 8** in the tanh-domain for $\text{card}(\mathcal{M}(n)) = 3$. Fig. 8 shows the main computation block 606 and the interface to the trellis decoder 118 for a variable degree 3 (3 "ones" per column in **H).** In order to illustrate the behavior, we use an example. In a small example, let us consider decoding the 16-th column of the parity check matrix **H** resulting after the lifting operation of the matrix **A** given in equation (12). We have $\mathcal{M}(16) = \{5, 9, 13\}$ as the 16-th column of **H** contains 1s in rows 5, 9 and 13. We consider the first iteration and show the initial execution of the first column decoding stage which does not differ from the remaining ones. Fig. 7 shows the initial stage of the column-layered LDPC decoder 122 and the first iteration. Fig. 8 shows any intermediate iteration and finally, **Fig. 9** shows the circuit the for final iteration, which can be simplified as no writing back to the extrinsic memory 604 is required and no input values for a subsequent trellis execution need to be determined. Note that clipping functions 120 according to Fig. 1 are not shown for the sake of clarity, but they can be placed at the inputs and outputs of the trellis decoders 118 to improve performance if phase slips are present on the transmission channel 114.

The application of embodiments to Quasi-Cyclic (QC) LDPC codes is straightforward. Instead of processing every column of the parity check matrix **H,** every column of the lifting matrix **A** may be processed resulting in the parallel computation of *S* variables each. **Fig. 10** shows a block diagram of a processing block 1006 for carrying out column-layered variable node operations for a QC LDPC code according to equations (15), (16), and (17).

In addition to processing block 606, the processing block 1006 includes cyclic shifters 1010, 1020 required to implement a quasi-cyclic code based on a lifting matrix **A.** The decoder 122 can in this case compute S variable nodes in parallel. In order to align the check node edges to the same variable node, the decoder retrieves chunks of S check node entries from the check node memory, which are then aligned using shifters that make use of the respective shift defined by the lifting matrix **A.** In the following, we will not explicitly show anymore the shifters unless required, but assume that all operations can be carried out to QC LDPC codes by following the same approach.

**Fig. 11** shows an example for decoding the fourth column of the matrix **A** given in (QC) which corresponds to the columns 16-20 of the equivalent parity check-matrix **H.** Hence, the column-layered LDPC decoder stage 122 may be operable or configured to process S columns of the LDPC code's parity check matrix **H** in parallel, wherein the LDPC code's parity check matrix **H** is constructed from a lifting matrix **A** by replacing each element/entry of **A** with either an all-zero matrix of size $S \times S$ or a cyclically permuted identity matrix of size $S \times S$, depending on the element/entry of **A.** If protograph codes are used, the entries of **A** describing non-void entries may replaced by more general permutation matrices. Thereby a permutation matrix is a square binary matrix that has exactly one entry 1 in each row and each column and 0s elsewhere. A permutation matrix may be regarded as a generalization of a cyclic identity matrix. In case of a permutation matrix the shifter circuits 1010 and 1020 may be replaced by a more general permutation operation.

We can use a so-called box-plus and a so-called box-minus operations defined as

$$z = x \boxplus y = 2\tanh^{-1}\left(\tanh\left(\frac{x}{2}\right)\tanh\left(\frac{y}{2}\right)\right) = \log\left(\frac{1+e^{x+y}}{e^{x}+e^{y}}\right) = \operatorname{sgn}(x)\operatorname{sgn}(y)\phi\left(\phi\left(|x|\right)+\phi\left(|y|\right)\right) \quad (18)$$

with

$$\phi(x) = \log\left(\coth\left(x/2\right)\right) \quad (19)$$

and

$$x = z \boxminus y = 2\tanh^{-1}\left(\tanh\left(\frac{z}{2}\right)\Big/\tanh\left(\frac{y}{2}\right)\right) = \log\left(\frac{1-e^{z+y}}{e^{z}-e^{y}}\right) = \operatorname{sgn}(z)\operatorname{sgn}(y)\phi\left(\phi\left(|z|\right)-\phi\left(|y|\right)\right) \quad (20)$$

where the box-minus operation of equation (20) requires that |z| < |y| for real output (fulfilled if z has been computed by box-plus, i.e., is result of a previous check node computation; all the valid combinations of entries in the check node memory 602 and the extrinsic memory 604 fulfill this condition) and is not commutative. Using these two operations of equations (18) and (20), we can simply switch between the LPDC and trellis decoder domains and re-draw the column-layered LPDC decoder in a similar way as the conventional row-layered LPDC decoder. This is shown in Fig. 6, which however has no practical implications. We now see, in contrast to **Fig. 5a,** that the Trellis decoder 118 is now more independent of the LDPC decoding acts and can be executed concurrently. The interaction between both decoders 118 and 122 is now more limited and local, allowing for a potentially easier VLSI implementation. Note that the clipping functions 120 according to Fig. 1 are again not shown for the sake of clarity.

As the multiplications/divisions and the tanh/tanh$^{-1}$ conversions in the previous equations can be tedious in an actual implementation, we can use the logarithmic implementation based on equation (19) and we get the implementation of the column-layered variable node operations as shown in **Fig. 12.** In this case the entries $c_m$ in the check node memory 602 do not correspond to the values before, but they are represented in the logarithmic domain. We therefore have to change the computation rules that are given by (we use the same equation numbers but with a prime ' to denote the difference):

Initialization of check node memory 602 (corresponding to equation (13)):

$$\operatorname{sgn}(c_m) = \prod_{j\in\mathcal{N}(m)} \operatorname{sgn}(\hat{z}_j) \qquad \text{for all } m \in [1; M]$$
$$|c_m| = \prod_{j\in\mathcal{N}(m)} \phi(|\hat{z}_j|) = \prod_{j\in\mathcal{N}(m)} \log\left(\coth\left(\frac{|\hat{z}_j|}{2}\right)\right) \qquad \text{for all } m \in [1; M] \tag{13'}$$

Initialization of extrinsic memory 604 (corresponding to equation (14)):

$$\operatorname{sgn}(e_{n,m}^{(l)}) = \operatorname{sgn}(\hat{z}_n)$$
$$|e_{n,m}^{(l)}| = \phi(|\hat{z}_n|) = \log\left(\coth\left(\frac{|\hat{z}_n|}{2}\right)\right) \text{ for all n = 1...N} \tag{14'}$$

The logarithmic processing acts (15') to (17') correspond to the tanh/tanh$^{-1}$ processing acts according to equations (15) to (17) above, except that due to the logarithmic domain, all multiplications have to be replaced by additions, all divisions by subtractions and vice-versa. This is shown in Fig. 12 (compare also Fig. 8, for example).

If the min-sum or the offset min-sum decoding algorithm shall be employed, the column-layered LDPC decoder 122 can be further simplified according to some embodiments. In this case, the check node memory 602 can track a sorted list of the incoming messages (denoted min*i*, *i*=1...$d_c$, with mini ≤ min2 ≤ min3 ≤ min4 ≤ ...) together with the associated variable nodes pos*i*. Depending on pos*i* (being *n* or not) either the first or the second minimum is chosen, or a correction factor $\beta$ is computed based on all minima and then subtracted from either the first or second minimum (see equation (8)) resulting in cmin1 and cmin2. If the extrinsic information has been computed, the extrinsic memory 604 can be updated by inserting the absolute value of the extrinsic information into the position min/ with *j* such that pos*j* = *n* and the list has to be sorted accordingly. This is shown for a single of the $d_v$ connections in **Fig. 13.** It has been shown in Z. Cui, Z. Wang, and X. Zhang, "Reduced-Complexity Column-Layered Decoding and Implementation for LDPC Codes," IET Communications that a shortened list with only three entries (mini, min2, and min3) can lead to approximately the same performance compared to a full list, with significantly reduced memory requirements. Such a reduced implementation is shown in **Fig. 14.** Note that with such an implementation as shown in Fig.13 and/or Fig. 14, the content of the extrinsic memory 604 is merely a sign, i.e., 1 bit is needed per entry. The overall memory requirement for the extrinsic memory 604 thus corresponds to the total number of "ones" in **H** or to S times the number of non-void entries in **A,** if a QC code is used.

As already mentioned above, the column-layered LDPC decoding algorithm implies an operational overhead *O* = *N*/*M,* which is especially significant if the code rate is high, i.e., *N* >> *M*. This is shown by means of a quasi-cyclic parity-check matrix in **Fig. 15a,** where the operational overhead is *O* = 8. With a group shuffled decoder according to J. Zhang and M. P. C. Fossorier, "Shuffled Iterative Decoding," IEEE Trans. Communications, vol. 53, no. 2, Feb. 2005, we can process two neighboring (chunks of) variable nodes, however, this has the disadvantage that they access different check node memory locations, thus increasing the access bandwidth of the check node memory 602. This situation is shown in **Fig. 15b.**

Embodiments therefore also propose a new quasi-cyclic code construction, which may be termed "multi-column quasi-cyclic codes". Let us first define a multiple column grouping factor *L*. According to embodiments the lifting matrix **A** of an *L*-multiple column LDPC code has the following property

$$\begin{cases} A_{i',j} \neq -1 & \text{if } A_{i,j} \neq -1 \\ A_{i',j} = -1 & \text{if } A_{i,j} = -1 \end{cases} \text{for all } i = 1, 1+L, 1+2L, \ldots \text{ and } i' = i+1, i+2, \ldots, i+L-1. \tag{21}$$

Equation (21) means that an entry $A_{i',j}$ of the $i'$-th column and the $j$-th row is set to -1 if an entry $A_{i,j}$ of the lifting matrix **A** of the $i$-th column and the $j$-th row is -1. That is to say, if the $i$-th value of row $j$ is -1 than the $L$-1 values neighboring the $i$-th value will also be set to -1. However, if the $i$-th value of row $j$ differs from -1 than the $L$-1 values neighboring the $i$-th value will also differ from -1. Thereby $i$ = 1,1 + $L$,1 + $2L$,... and $i'$= $i$ + 1, $i$ + 2,..., $i$ + $L$ - 1, with the multiple column grouping factor $L$ being an integer. This leads to a novel lifting matrix **A** which can be now interpreted as generated from a super-lifting matrix $\mathbf{A}_{\text{super}}$ of dimension $M\times(N/L)$, i.e., the $N$-dimension is sub-divided and the lifting matrix **A** is now not composed of chunks of $SxS$ cyclically shifted identity matrices but by $S\times LS$ groups of $L$ shifted identity matrices. This is illustrated in **Figs. 16a** and **16b** for the cases $L$ = 2 and $L$ = 3. The super-lifting matrix $\mathbf{A}_{\text{super}}$ only contains entries "-1" denoting a group of $L$ "-1" entries in **A** and entries $e$ denoting a group of $L$ entries different from "-1". The entry $e$ encodes the $L$ neighboring entries by the decimal representation of the $L$-digit $S$-ary number. For the example with $S$=5 and $L$=3, $e$ = 29 corresponds to (104), as $1.5^2 + 0.5 + 4 = 29$.

An example "multi-column quasi-cyclic code" lifting matrix **A** (together with its super-lifting matrix $\mathbf{A}_{\text{super}}$) and the corresponding parity check matrix **H** for $L$=2 are given in the following example:

$$\mathbf{A}_{\text{super}} = \begin{pmatrix} -1 & 8 & 10 \\ 11 & 22 & 7 \\ 8 & -1 & 5 \end{pmatrix}$$

$$\mathbf{A} = \begin{pmatrix} -1 & -1 & 1 & 3 & 2 & 0 \\ 2 & 1 & 4 & 2 & 1 & 2 \\ 1 & 3 & -1 & -1 & 1 & 0 \end{pmatrix} \rightarrow \mathbf{H} = \left(\begin{array}{ccccc|ccccc|ccccc|ccccc|ccccc|ccccc}
&&&& & &&&& & &1&&& & &&&1& & &&1&& & 1&&&& \\
&&&& & &&&& & &&1&& & &&&&1 & &&&1& & &1&&& \\
&&&& & &&&& & &&&1& & 1&&&& & &&&&1 & &&1&& \\
&&&& & &&&& & &&&&1 & &1&&& & 1&&&& & &&&1& \\
&&&& & &&&& & 1&&&& & &&1&& & &1&&& & &&&&1 \\
\hline
&&1&& & &1&&& & &&&&1 & &&1&& & &1&&& & &&1&& \\
&&&1& & &&1&& & 1&&&& & &&&1& & &&1&& & &&&1& \\
&&&&1 & &&&1& & &1&&& & &&&&1 & &&&1& & &&&&1 \\
1&&&& & &&&&1 & &&1&& & 1&&&& & &&&&1 & 1&&&& \\
&1&&& & 1&&&& & &&&1& & &1&&& & 1&&&& & &1&&& \\
\hline
&1&&& & &&&1& & &&&& & &&&& & &1&&& & 1&&&& \\
&&1&& & &&&&1 & &&&& & &&&& & &&1&& & &1&&& \\
&&&1& & 1&&&& & &&&& & &&&& & &&&1& & &&1&& \\
&&&&1 & &1&&& & &&&& & &&&& & &&&&1 & &&&1& \\
1&&&& & &&1&& & &&&& & &&&& & 1&&&& & &&&&1
\end{array}\right) \quad (22)$$

It can be seen that $A_{1,1}$ and $A_{2,1}$ as well as $A_{3,3}$ and $A_{4,3}$ are -1 as $A_{\text{super},1,1}$ and $A_{\text{super},3,2}$ are -1. As $L$ = 2 entries of -1 will always appear pairwise in the "toy example" of **A.** Note that "-1" could be replaced by any other adequate predetermined value leading to zero entries in the parity check matrix. Consider the entry $A_{\text{super},2,1} = 11 = 2\cdot S^1+1\cdot S^0$, leading to $A_{2,1}$ = 2 and $A_{2,2}$ = 1. Correspondingly, the entry $A_{\text{super},2,2} = 22 = 4\cdot S^1+2\cdot S^0$ leads to $A_{2,3}$ = 4 and $A_{2,4}$ = 2, etc.

This has several implications: First, with such an approach, the check node degrees are integer multiples of $L$. Secondly, such a QC LDPC code ensures that an LDPC decoder 122 can now decode $L$ consecutive blocks of **A** in parallel and can thus exchange $LS$ bits per decoding operation with the trellis decoder 118. This is illustrated in **Fig. 17** showing a decoder 600 according to an embodiment which is operable to carry out $L$ = 2 variable node operations 606-1, 606-2 corresponding to $L$ = 2 adjacent columns of **A** in parallel (corresponding to processing $LS$ adjacent columns of **H** in parallel). In Fig. 17 the tanh-domain operations have been replaced by the aforementioned box-plus and box-minus operations of equations (18) - (20), respectively.

A decoder 122 for a QC LDPC with L=2 and the tanh/tanh$^{-1}$ operations is shown in **Fig. 18** for a variable node of degree 2 (two non-void entries per column in **A,** or $\mathbf{A}_{\text{super}}$, respectively), where $L$=2 blocks 610-1, 610-2 of LLRs for the differential decoder 118 may be obtained in parallel within a single decoding act. That is to say, $L\cdot S$ entries corresponding to variable nodes of the parity check matrix **H** may be computed or updated in parallel. Once the check node data has been fetched, two distinct sets of edge information can be obtained by "box-subtracting" (i.e., here dividing) the respective extrinsic information and then after generation of the new edge information, the a-posteriori data and hence the new input data 610-1, 610-2 for the differential detector 118, we can recover the check node information by box-adding all the $L$ data to the remainder edges (which have been computed as a side product). Note that the input data 610-1 and 610-2 are not a-posteriori but a-posteriori minus old input (thus extrinsic), and thus the new input data for the differential detector. One check node connection for such a QC LDPC decoder with $L$=2 operating using the min-sum algorithm is shown in **Fig. 19.**

Some examples may hence also be employed on transmitter side as an encoder 106 for encoding an LDPC code word in accordance with a parity check matrix of an LDPC code may be provided. Thereby the parity check matrix **H** is constructed from a super-lifting matrix $\mathbf{A}_{super}$ via an intermediate lifting matrix **A** by replacing each entry of **A** with either an all-zero matrix of size $S \times S$ or a permutation matrix, e.g. a cyclically permuted identity matrix, of size $S \times S$, depending on the entry of **A,** or a superposition of permutation matrices of size $S \times S$. An entry $A_{i',j}$ of the $i'$-th column and the $j$-th row of the lifting matrix **A** is -1 (or any other corresponding predetermined value leading to void entries) if an entry $A_{i,j}$ of the $i$-th column and the $j$-th row of the lifting matrix **A** is -1 (or any other corresponding predetermined value leading to void entries), wherein $i = 1, 1+L, 1+2L, \ldots$ and $i' = i+1, i+2, \ldots, i+L-1$, with $L$ being an integer.

Let us consider in an example the case $L = 2$. For each of the dv check node connections of a group of L variable nodes, the decoder now needs to compute $L$=2 temporary values

$$t_{n,i} = \frac{c_i}{e_{n,i}^{(l)}} \qquad \text{for all } i \in \mathcal{M}(n)$$

$$t_{n',i} = \frac{c_i}{e_{n',i}^{(l)}} \qquad \text{for all } i \in \mathcal{M}(n') = \mathcal{M}(n)$$

where the 2-tuple $(n,n')$ indicates the two variable node connections corresponding to the two variable node connections in a row chunk, i.e., in two neighboring chunks of size $S$ of the parity check matrix, or corresponding to two neighboring entries of the lifting matrix **A,** or finally corresponding to a single entry of the super-lifting matrix $\mathbf{A}_{super}$. Additionally, we need to compute the temporary value $w_{n,i}$ which amounts to $w_{n,i} = \frac{c_i}{e_{n,i}^{(l)} \cdot e_{n',i}^{(l)}}$ for all $i \in \mathcal{M}(n)$

Both a-posteriori values for positions $n$ and $n'$ can be computed using e.g., (16) of variants thereof.

$$v_n = \hat{z}_n + 2 \sum_{i \in \mathcal{M}(n)} \tanh^{-1}\left(t_{n,i}\right)$$

$$v_{n'} = \hat{z}_{n'} + 2 \sum_{i \in \mathcal{M}(n') = \mathcal{M}(n)} \tanh^{-1}\left(t_{n',i}\right)$$

Finally, the extrinsic memory 604 and the check node memory 602 are updated according to

$$e_{n,i}^{(l+1)} = \tanh\left(\frac{v_n - 2\tanh^{-1}(t_{n,i})}{2}\right)$$

$$e_{n',i}^{(l+1)} = \tanh\left(\frac{v_{n'} - 2\tanh^{-1}(t_{n',i})}{2}\right)$$

$$c_i = e_{n,i}^{(l+1)} \cdot e_{n',i}^{(l+1)} \cdot w_{n,i}$$

An example illustrating the operation of the multi-column-layered decoder for the application of the aforementioned $L$=2 example matrix is shown in **Fig. 18a** for the second column of $\mathbf{A}_{super}$ introduced above, corresponding to the third and fourth column of **A** and thus to the 11th to 20th column of **H** (by parallel computation of S=5 entries each).

Sometimes, especially if $L$ is chosen large, it may not be tolerated that the check node degree shall be an integer multiple of $L$. Thereby the degree of a check node is the number of edges or variable nodes connected to it and corresponds to the number of non-zero entries per row of **H** corresponding to a check node. In this case, embodiments may employ a mask that ensures that some entries of the lifting matrix **A** (and hence the parity check matrix **H)** are blanked and set to void. The above condition of equation (21) may then be modified corresponding to

$A_{i',j}$ = -1 if $A_{i,j}$ = -1 for all $i$ =1,1 + $L$,1 + 2$L$,... and $i'$= $i$ + 1,$i$ + 2,...,$i$ + $L$-1. (23) In contrast to equation (21) this means that even if the $i$-th value of row $j$ differs from-1 (or any other corresponding predetermined value leading to void entries) than nevertheless at least some of the $L$-1 values neighboring the $i$-th value may be masked out, i.e. set to -1. That is to say, an entry $A_{i',j}$ of the $i'$-th column and the $j$-th row of the lifting matrix **A** may be masked out (or not) if an entry $A_{i,j}$ of the $i$-th column and the $j$-th row of the lifting matrix **A** differs from -1 (or any other corresponding predetermined value leading to void entries), wherein $i$ =1,1+ $L$,1 + 2$L$,... and $i'$ = $i$ +1,$i$ + 2,...,$i$ + $L$-1, with $L$ being an integer.

An example of a masked QC LDPC code is shown in **Fig. 20** for the case $L$ = 4. The masked entries are marked by the circles. Four entries of the lifting matrix **A** are masked. The initial code had a degree distribution of $R_{40}$=1/11, $R_{16}$=9/11, $R_{12}$=1/11, with $R_i$ denoting the fraction of check nodes of degree $i$. With the masking as proposed here, the masked code has a degree distribution of $R_{38}$=1/11, $R_{16}$=7/11, $R_{15}$=2/11, $R_{12}$=1/11. This means that with masking, embodiments can realize a degree distribution with higher granularity and thus realize QC LDPC codes that have a degree profile that better fits the differential decoder 118 characteristic. A drawback of the masked multiple column LDPC codes is that the corresponding LDPC decoder 122 is slightly more complicated, as an additional switch for disabling an entry in the lifting matrix **A** has to be accounted for. Note that we may assume that the first entry in an $L$ block is never masked, i.e., the entry of **A** at column 1,1+$L$, 1+2$L$, 1+3$L$, ... An example for such a decoder using this assumption for the $L$=2 case is shown in **Fig. 20a.** The masking is accounted for by the switches 2002 in the respective lower branches of the block diagram. Using the switches these branches can be bypassed in the computation by feeding predetermined values at the inputs such that only one branch carries out the actual computation.

Some results are shown for an exemplary setup in **Figs. 21** and **22.** We have chosen a code of rate 0.8625 with lifting factor S = 300 and dim(**H**)=3300x24000**.** We have fixed the variable node degree distribution to 55% degree-2 nodes are 45% degree-3 variable nodes. We did not employ masking. We have optimized the codes using the procedure mentioned below with maximum check node degree 40. For $L$=1, all degrees are valid, for $L$=2, only check node degrees that are a multiple of 2 and for $L$=4 only check node degrees that are a multiple of 4. We optimized a code for each degree distribution separately.

Fig. 20 shows the simulation results for 12 decoding iterations with the differential decoder 122 being executed in each iteration. We can see that the $L$-multiple column LDPC codes for $L$=1 and $L$=2 perform almost equally. Astonishingly, the code for $L$=2 is slightly better in performance, which can be due to the different parity check matrices and different girth distributions. For $L$=4 we can observe a small loss. This loss is not only due to the possibly slower convergence, but due to the fact that the selection of check node degrees that are only a multiple of 4 limits the search space for the code and a less optimal degree distribution is found. This can be prevented by employing masking as described above.

Fig. 21 shows the convergence speed for different values of $E_b/N_0$ as well as the iterations required to reach the target BER of 3.8e-3, a typical value for outer hard decision error floor removal codes. As expected, the convergence is slowed down slightly, especially if we are operating close to the threshold. If we back up however a little from the threshold and operate at an $E_b/N_0$ where the $L$=1 code requires 10 iterations to converge to the target BER, we see that we require only around one additional iteration if we increase $L$ to 4. With a masked code and thus a better threshold, this factor may be further decreased.

Further, examples may also employ a mixed-integer code optimization procedure for optimizing the check degree distribution of a given variable node degree distribution λ(x) expressed in polynomial form as described in high detail in T. Richardson, and R. Ur-banke, "Modern Coding Theory", ISBN 9780521852296. Let $r_i$ denote the number of rows of degree $i$. Clearly, the node-degree degree distribution is given by $R_i = r_i/M$, with $M$ denoting the number of rows in the parity check or protograph matrix. Thereby a protograph can be any Tanner graph, typically one with a relatively small number of nodes. The degree distribution is commonly expressed by means of a polynomial

$$R(x) = \frac{1}{M}\sum r_i x^i \qquad (24)$$

The edge-perspective degree distribution is given in polynomial form by

$$\rho(x) = \sum \rho_i x^{i-1} = \frac{R'(x)}{R'(1)} = \frac{\sum i r_i x^{i-1}}{\sum i r_i} \qquad (25)$$

In vector notation, if we set r = $(r_1, r_2, ..., r_D)^T$ with $D$ denoting the maximum allowable check node degree, and if we let t = $(1/M, 2/M, ..., D/M)^T$, i.e., $t_i = i/M$ we get

$$\rho_i = \frac{t_i r_i}{\mathbf{t}^T \mathbf{r}} \qquad (26)$$

We now denote by v the vector containing the inverse combined differential detector/variable node decoder EXIT characteristic (see S. ten Brink, G. Kramer, and A. Ashi-khmin, "Design of Low-Density Parity-Check Codes for Modulation and Detection", IEEE Transactions on Communications, vol. 52, no. 4, April 2004), then the condition $C\bar{\rho}$>v (27) translates to

$$\mathbf{C} \cdot \mathrm{diag}(\mathbf{t}) \cdot \mathbf{r} > (\mathbf{t}^T \mathbf{r})\mathbf{v} \,. \qquad (28)$$

The goal of the code design is to maximize the rate of the code for a given channel quality. The rate of the LDPC code is given by

$$Rate = 1 - \frac{\int_0^1 \rho(x)dx}{\int_0^1 \lambda(x)dx} = 1 - C\int_0^1 \rho(x)dx = 1 - C\sum \frac{\rho_i}{i} = 1 - \frac{C}{\mathbf{t}^T \mathbf{r}} \sum \frac{t_i}{i} r_i = 1 - \frac{C}{M \cdot \mathbf{t}^T \mathbf{r}} \sum r_i = 1 - \frac{C}{\mathbf{t}^T \mathbf{r}} \qquad (29)$$

as the sum of all entries in **r** amounts *M. C* is a constant that depends on the (fixed) variable node degree distribution. The maximization of the rate thus corresponds to the maximization of $\mathbf{t}^T\mathbf{r}$. The optimization of the degree profile of the code can then be formulated as the following mixed-integer routine where we optimize the -infinity norm (meaning that we wish to maximize the minimum opening in the EXIT tunnel). Note that the -infinty norm computes the minimum absolute value of a vector.

$$\begin{aligned}
&\mathbf{r}_{opt} = \arg\max_{\mathbf{r}} \| \mathbf{C} \cdot \mathrm{diag}(\mathbf{t}) \cdot \mathbf{r} - (\mathbf{t}^T \mathbf{r})\mathbf{v} \|_{-\infty} \\
&\text{subject to} \\
&\mathbf{C} \cdot \mathrm{diag}(\mathbf{t}) \cdot \mathbf{r} > (\mathbf{t}^T \mathbf{r})\mathbf{v} \\
&\sum r_i = M \\
&\sum i r_i = E \\
&r_i \geq 0 \\
&r_1 = 0 \\
&r_i = 0 \text{ if } i \not\equiv 0 \bmod L \\
&r_i \ \text{ integer}
\end{aligned} \qquad (30)$$

with E being the number of edges in the graph given by the (fixed) variable node degree distribution. This mixed-integer linear routine can be solved using standard solvers for mixed integer problems, e.g., a branch-and-bound algorithm. The constraint before last ensures that the degree of all utilized check nodes is a multiple of *L*, such that a multiple-column code can be constructed.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. Decoder (600) for iteratively decoding a received signal generated by encoding an LDPC code word with a differential code, the decoder (600) comprising:

   a differential decoder (118) operable to provide extrinsic probability information on the LDPC code word based on the received signal and a-priori probability information on the received signal;
   a column-layered LDPC decoder (122) operable to process columns of the LDPC code's parity check matrix based on the extrinsic probability information from the differential decoder (118) to obtain updated a-priori probability information for the differential decoder (118);
   wherein the column-layered LDPC decoder (122) is operable to process S columns of the LDPC code's parity check matrix (H) in parallel, wherein the LDPC code's parity check matrix (H) is constructed from a lifting matrix A by replacing each entry of the lifting matrix (A) with either an all-zero matrix of size SxS or a permutation matrix of size SxS or a superposition of multiple permutation matrices of size SxS, depending on the entry of A, and wherein an entry $A_{i',j}$ of the i'-th column and the j-th row of the lifting matrix (A) is x if an entry $A_{i,j}$ of the i-th column and the j-th row of the lifting matrix A is x, wherein x denotes a predetermined value leading to void entries in the corresponding LDPC code's parity check matrix (H), and wherein i = 1,1 + L,1 + 2L,... and i'= i + 1,i + 2, ... ,i + L-1, with L being an integer..

2. The decoder (600) of claim 1, wherein the differential decoder stage is operable to provide the extrinsic probability information based on a trellis-based decoding rule of the received signal.

3. The decoder (600) of claim 1, wherein the column-layered LDPC decoder (122) comprises a check node memory (602) having M check node memory cells, with M denoting a number of rows of the LDPC code's parity check matrix, wherein the column-layered LDPC decoder (122) comprises an extrinsic memory (604) and
   wherein the column-layered LDPC decoder (122) is operable to initialize an *m-th* memory cell of the check node memory corresponding to

$$c_m = \prod_{j \in \mathcal{N}(m)} \tanh\left(\frac{\hat{z}_j}{2}\right) \qquad \textit{for all } m \in [1; M]$$

   or an approximation thereof, and to initialize a memory cell of the extrinsic memory (604) corresponding to an *n-th*

column and an m-th row of the LDPC code's parity check matrix corresponding to

$$e_{n,m}^{(l)} = \tanh\left(\frac{\hat{z}_n}{2}\right) \qquad \textit{for all } n = 1 \ldots N$$

or an approximation thereof, wherein $\hat{z}_n$ denotes the n-th entry of the extrinsic probability information on the LDPC code word.

**4.** The decoder (600) of claim 3, wherein the column-layered LDPC decoder (122) is operable to determine first temporary information corresponding to an n-th column and an i-th row of the LDPC code's parity check matrix corresponding to

$$t_{n,i} = \frac{c_i}{e_{n,i}^{(l)}} \qquad \textit{for all } i \in \mathcal{M}(n)$$

or an approximation thereof, wherein $c_i$ denotes an entry of an i-th memory cell of the check node memory (602), $e_{n,i}^{(l)}$ denotes an entry of a memory cell of the extrinsic memory (604) corresponding to an n-th column and an i-th row of the LDPC code's parity check matrix in an 1-th iteration, and $\mathcal{M}(n)$ denotes a set of positions of ones in the n-th column of the LDPC code's parity check matrix.

**5.** The decoder (600) of claim 4, wherein the column-layered LDPC decoder (122) is operable to determine an a-posteriori output corresponding to an n-th column of the LDPC code's parity check matrix corresponding to

$$v_n = \hat{z}_n + 2 \sum_{i \in \mathcal{M}(n)} \tanh^{-1}\left(t_{n,i}\right),$$

or an approximation thereof.

**6.** The decoder (600) of claim 5, wherein the column-layered LDPC decoder (122) is operable to obtain the updated a-priori probability information for the differential decoder (118) corresponding to an n-th column of the LDPC code's parity check matrix corresponding to $u_n = v_n - \hat{z}_n$ or an approximation thereof.

**7.** The decoder (600) of claim 5, wherein the column-layered LDPC decoder (122) is operable to determine an updated entry of a memory cell of the extrinsic memory (604) corresponding to an n-th column and an i-th row of the LDPC code's parity check matrix for an (1+1)-th iteration of the decoder (600) corresponding to

$$e_{n,i}^{(l+1)} = \tanh\left(\frac{v_n - 2\tanh^{-1}\left(t_{n,i}\right)}{2}\right)$$

or an approximation thereof, and to update an i-th memory cell of the check node memory (602) corresponding to $c_i = e_{n,i} \cdot t_{n,i'}$
or an approximation thereof.

**8.** The decoder (600) of claim 7, wherein an entry $A_{i',j}$ of the i'-th column and the j-th row of the lifting matrix (A) is masked if an entry $A_{i,j}$ of the i-th column and the j-th row of the lifting matrix (A) differs from the predetermined value, wherein a masked entry of the lifting matrix (A) yields a void entry in the corresponding parity check matrix (H).

**9.** The decoder (600) of claim 7, wherein the lifting matrix (A) is based on a super-lifting matrix ($A_{super}$) comprising entries x denoting a group of L adjacent x entries in the lifting matrix (A) and comprising entries denoting a group of L adjacent entries different from x in the lifting matrix (A) .

**10.** A method for iteratively decoding a received signal generated by encoding an LDPC code word with a differential code, the method comprising:

differentially decoding the received signal to provide extrinsic probability information on the LDPC code word based on a-priori probability information on the received signal;
decoding the LDPC code word by processing columns of the LDPC code's parity check matrix based on the provided extrinsic probability information to obtain updated a-priori probability information for a next iteration of differentially decoding;
wherein the column-layered LDPC decoder (122) is operable to process S columns of the LDPC code's parity check matrix (H) in parallel, wherein the LDPC code's parity check matrix (H) is constructed from a lifting matrix A by replacing each entry of the lifting matrix (A) with either an all-zero matrix of size SxS or a permutation matrix of size SxS or a superposition of multiple permutation matrices of size SxS, depending on the entry of A, and wherein an entry $A_{i,j}$ of the i'-th column and the j-th row of the lifting matrix (A) is x if an entry $A_{i,j}$ of the i-th column and the j-th row of the lifting matrix A is x, wherein x denotes a predetermined value leading to void entries in the corresponding LDPC code's parity check matrix (H), and wherein i = 1,1 + L,1 + 2L,... and i'= i + 1,i + 2, ... ,i + L-1, with L being an integer.

**11.** A computer program having a program code for performing the method of claim 10, when the computer program is executed on a computer or processor.

**Patentansprüche**

**1.** Decodierer (600) zum iterativen Decodieren eines empfangenen Signals, das durch Codieren eines LDPC-Codeworts mit einem differenziellen Code erzeugt wird, wobei der Decodierer (600) Folgendes umfasst:

einen differenziellen Decodierer (118), der betreibbar ist, auf Basis des empfangenen Signals und von A-priori-Wahrscheinlichkeitsinformationen zum empfangenen Signal extrinsische Wahrscheinlichkeitsinformationen zum LDPC-Codewort bereitzustellen;
einen spaltengeschichteten LDPC-Decodierer (122), der betreibbar ist, auf Basis der extrinsischen Wahrscheinlichkeitsinformationen vom differenziellen Decodierer (118) Spalten der Paritätsprüfungsmatrix des LDPC-Codes zu verarbeiten, um aktualisierte A-priori-Wahrscheinlichkeitsinformationen für den differenziellen Decodierer (118) zu erhalten;
wobei der spaltengeschichtete LDPC-Decodierer (122) betreibbar ist, S Spalten der Paritätsprüfungsmatrix (H) des LDPC-Codes gleichzeitig zu verarbeiten, wobei die Paritätsprüfungsmatrix (H) des LDPC-Codes durch Ersetzen jedes Eintrags einer Liftingmatrix (A) durch eine Matrix nur mit Nullen der Größe SxS oder eine Permutationsmatrix der Größe SxS oder eine Überlagerung von mehreren Permutationsmatrices der Größe SxS in Abhängigkeit vom Eintrag von A aus einer Liftingmatrix A konstruiert ist und
wobei ein Eintrag $A_{i',j}$ der i'-ten Spalte und der j-ten Zeile der Liftingmatrix (A) x ist, wenn ein Eintrag $A_{i,j}$ der i-ten Spalte und der j-ten Zeile der Liftingmatrix A x ist, wobei x einen vorbestimmten Wert bezeichnet, der zu leeren Einträgen in der Paritätsprüfungsmatrix (H) des entsprechenden LDPC-Codes führt, und wobei i = 1,1 + L, 1 + 2L,... und i' = i + 1,i + 2, ... , i + L-1, wobei L eine Ganzzahl ist.

**2.** Decodierer (600) nach Anspruch 1, wobei die differenzielle Decodiererstufe betreibbar ist, die extrinsischen Wahrscheinlichkeitsinformationen auf Basis einer gitterbasierten Decodierregel des empfangenen Signals bereitzustellen.

**3.** Decodierer (600) nach Anspruch 1, wobei der spaltengeschichtete LDPC-Decodierer (122) einen Prüfknotenspeicher (602) mit *M* Prüfknotenspeicherzellen umfasst, wobei *M* eine Anzahl von Zeilen der Paritätsprüfungsmatrix des LDPC-Codes bezeichnet, wobei der spaltengeschichtete LDPC-Decodierer (122) einen extrinsischen Speicher (604) umfasst und
wobei der spaltengeschichtete LDPC-Decodierer (122) betreibbar ist, eine *m*-te Speicherzelle des Prüfknotenspeichers entsprechend Folgendem zu initialisieren

$$c_m = \prod_{j \in \mathcal{N}(m)} \tanh\left(\frac{\hat{z}_j}{2}\right) \text{für alle } m \in [1; M]$$

oder einer Annäherung davon und eine Speicherzelle des extrinsischen Speichers (604), die einer *n-ten* Spalte und einer m-ten Zeile der Paritätsprüfungsmatrix des LDPC-Codes entspricht, entsprechend Folgendem zu initialisieren

$$e_{n,m}^{(l)} = \tanh\left(\frac{\hat{z}_n}{2}\right) \quad \texttt{für alle } n = 1...N$$

oder einer Annäherung davon, wobei $\hat{z}_n$ den n-ten Eintrag der extrinsischen Wahrscheinlichkeitsinformationen des LDPC-Codeworts bezeichnet.

4. Decodierer (600) nach Anspruch 3, wobei der spaltengeschichtete LDPC-Decodierer (122) betreibbar ist, erste temporäre Informationen, die einer n-ten Spalte und einer i-ten Zeile der Paritätsprüfungsmatrix des LDPC-Codes entsprechen, entsprechend Folgendem zu bestimmen

$$t_{n,i} = \frac{c_i}{e_{n,i}^{(l)}} \qquad \texttt{für alle} \quad i \in \mathcal{M}(n)$$

oder einer Annäherung davon, wobei $c_i$ einen Eintrag einer 10 i-ten Speicherzelle des Prüfknotenspeichers (602) bezeichnet, $e_{n,i}^{(l)}$ einen Eintrag einer Speicherzelle des extrinsischen Speichers (604), die einer n-ten Spalte und einer i-ten Zeile der Paritätsprüfungsmatrix des LDPC-Codes bei einer l-ten Iteration bezeichnet und $\mathcal{M}(n)$ einen Satz von Positionen in der n-ten Spalte der Paritätsprüfungsmatrix des LDPC-Codes bezeichnet.

5. Decodierer (600) nach Anspruch 4, wobei der spaltengeschichtete LDPC-Decodierer (122) betreibbar ist, eine A-posteriori-Ausgabe, die einer n-ten Spalte der Paritätsprüfungsmatrix des LDPC-Codes entspricht, entsprechend Folgendem zu bestimmen

$$v_n = \hat{z}_n + 2 \sum_{i \in \mathcal{M}(n)} \tanh^{-1}(t_{n,i}),$$

oder einer Annäherung davon.

6. Decodierer (600) nach Anspruch 5, wobei der spaltengeschichtete LDPC-Decodierer (122) betreibbar ist, die aktualisierten A-priori-Wahrscheinlichkeitsinformationen für den differenziellen Decodierer (118), die einer n-ten Spalte der Paritätsprüfungsmatrix des LDPC-Codes

$$u_n = v_n - \hat{z}_n$$

entsprechen, entsprechend oder einer Annäherung davon zu erhalten.

7. Decodierer (600) nach Anspruch 5, wobei der spaltengeschichtete LDPC-Decodierer (122) betreibbar ist, einen aktualisierten Eintrag einer Speicherzelle des extrinsischen Speichers (604), die einer n-ten Spalte und einer i-ten Zeile der Paritätsprüfungsmatrix des LDPC-Codes entspricht, für eine (1+1)-te Iteration des Decodierers (600) entsprechend Folgendem zu bestimmen

$$e_{n,i}^{(l+1)} = \tanh\left(\frac{v_n - 2\tanh^{-1}(t_{n,i})}{2}\right)$$

oder einer Annäherung davon und eine i-te Speicherzelle des Prüfknotenspeichers (602) entsprechend Folgendem zu aktualisieren

$c_i = e_{n,i} \cdot t_{n,i'}$

oder einer Annäherung davon.

**8.** Decodierer (600) nach Anspruch 7, wobei ein Eintrag $A_{i',j}$ der i'-ten Spalte und der j-ten Zeile der Liftingmatrix (A) maskiert ist, wenn sich ein Eintrag $A_{i,j}$ der i-ten Spalte und der j-ten Zeile der Liftingmatrix (A) von dem vorbestimmten Wert unterscheidet, wobei ein maskierter Eintrag der Liftingmatrix (A) einen leeren Eintrag in der entsprechenden Paritätsprüfungsmatrix (H) ergibt.

**9.** Decodierer (600) nach Anspruch 7, wobei die Liftingmatrix (A) auf einer Superliftingmatrix ($A_{super}$) basiert, die Einträge x umfasst, die eine Gruppe von L benachbarten x-Einträgen in der Liftingmatrix (A) bezeichnen, und Einträge umfasst, die eine Gruppe von L benachbarten Einträgen, die sich von x unterscheiden, in der Liftingmatrix (A) bezeichnen.

**10.** Verfahren zum iterativen Decodieren eines empfangenen Signals, das durch Codieren eines LDPC-Codeworts mit einem differenziellen Code erzeugt wird, wobei das Verfahren Folgendes umfasst:

differenzielles Decodieren des empfangenen Signals, um auf Basis von A-priori-Wahrscheinlichkeitsinformationen zum empfangenen Signal extrinsische Wahrscheinlichkeitsinformationen zum LDPC-Codewort bereitzustellen;
Decodieren des LDPC-Codeworts durch Verarbeiten von Spalten der Paritätsprüfungsmatrix des LDPC-Codes auf Basis der bereitgestellten extrinsischen Wahrscheinlichkeitsinformationen, um aktualisierte A-priori-Wahrscheinlichkeitsinformationen für eine nächste Iteration des differenziellen Decodierens zu erhalten;
wobei der spaltengeschichtete LDPC-Decodierer (122) betreibbar ist, S Spalten der Paritätsprüfungsmatrix (H) des LDPC-Codes gleichzeitig zu verarbeiten, wobei die Paritätsprüfungsmatrix (H) des LDPC-Codes durch Ersetzen jedes Eintrags einer Liftingmatrix (A) durch eine Matrix nur mit Nullen der Größe SxS oder eine Permutationsmatrix der Größe SxS oder eine Überlagerung von mehreren Permutationsmatrices der Größe SxS in Abhängigkeit vom Eintrag von A aus einer Liftingmatrix A konstruiert ist und
wobei ein Eintrag $A_{i',j}$ der i'-ten Spalte und der j-ten Zeile der Liftingmatrix (A) x ist, wenn ein Eintrag $A_{i,j}$ der i-ten Spalte und der j-ten Zeile der Liftingmatrix A x ist, wobei x einen vorbestimmten Wert bezeichnet, der zu leeren Einträgen in der Paritätsprüfungsmatrix (H) des entsprechenden LDPC-Codes führt, und wobei i = 1,1 + L,1 + 2L,... und i'= i + 1, i + 2, ... , i + L-1, wobei L eine Ganzzahl ist.

**11.** Computerprogramm, das einen Programmcode zum Durchführen des Verfahrens nach Anspruch 10, wenn das Computerprogramm auf einem Computer oder Prozessor ausgeführt wird, aufweist.

## Revendications

**1.** Décodeur (600) pour décoder de manière itérative un signal reçu généré par le codage d'un mot de code à contrôle de parité à faible densité, LDPC, avec un code différentiel, le décodeur (600) comprenant :

un décodeur différentiel (118) apte à fonctionner pour fournir des informations de probabilité extrinsèque sur le mot de code LDPC sur la base du signal reçu et d'informations de probabilité a priori sur le signal reçu ;
un décodeur LDPC stratifié en colonnes (122) apte à fonctionner pour traiter des colonnes de la matrice de contrôle de parité du code LDPC sur la base des informations de probabilité extrinsèque provenant du décodeur différentiel (118) pour obtenir des informations de probabilité a priori mises à jour pour le décodeur différentiel (118) ;
dans lequel le décodeur LDPC stratifié en colonnes (122) est apte à fonctionner pour traiter S colonnes de la matrice de contrôle de parité du code LDPC (H) en parallèle, dans lequel la matrice de contrôle de parité du code LDPC (H) est construite à partir d'une matrice de transfert A par le replacement de chaque entrée de la matrice de transfert (A) avec soit une matrice remplie de zéros de taille SxS soit une matrice de permutation de taille SxS soit une superposition de multiples matrices de permutation de taille SxS, en fonction de l'entrée de A, et
dans lequel une entrée $A_{i',j}$ de la i'-ème colonne et de la j-ème rangée de la matrice de transfert (A) est x si une entrée $A_{i,j}$ de la i-ème colonne et de la j-ème rangée de la matrice de transfert A est x, dans lequel x représente une valeur prédéterminée conduisant à des entrées vides dans la matrice de contrôle de parité du code LDPC (H) correspondante, et dans lequel i = 1, 1+L, 1+2L, ... et i' = i+1, i+2, ..., i+L-1, L étant un nombre entier.

**2.** Décodeur (600) selon la revendication 1, dans lequel l'étage de décodeur différentiel est apte à fonctionner pour fournir les informations de probabilité extrinsèque sur la base d'une règle de décodage basée sur treillis du signal reçu.

**3.** Décodeur (600) selon la revendication 1, dans lequel le décodeur LDPC stratifié en colonnes (122) comprend une mémoire de nœud de contrôle (602) ayant *M* cellules de mémoire de nœud de contrôle, *M* représentant un nombre de rangées de la matrice de contrôle de parité du code LDPC,
dans lequel le décodeur LDPC stratifié en colonnes (122) comprend une mémoire extrinsèque (604) et
dans lequel le décodeur LDPC stratifié en colonnes (122) est apte à fonctionner pour initialiser une *m-ième* cellule de mémoire de la mémoire de nœud de contrôle correspondant à

$$c_m = \prod_{j \in \mathcal{N}(m)} \tanh\left(\frac{\hat{z}_j}{2}\right) \qquad pour\ tous\ les\ m \in [1;M]$$

ou à une approximation de ceci, et pour initialiser une cellule de mémoire de la mémoire extrinsèque (604) correspondant à une *n-ième* colonne et à une m-ième rangée de la matrice de contrôle de parité du code LDPC correspondant à

$$e_{n,m}^{(l)} = \tanh\left(\frac{\hat{z}_n}{2}\right) \qquad pour\ tous\ les\ n = 1 \ldots N$$

ou à une approximation de ceci, dans lequel $\hat{z}_n$ représente la n-ième entrée des informations de probabilité extrinsèque sur le mot de code LDPC.

**4.** Décodeur (600) selon la revendication 3, dans lequel le décodeur LDPC stratifié en colonnes (122) est apte à fonctionner pour déterminer des premières informations temporaires correspondant à une n-ième colonne et à une i-ème rangée de la matrice de contrôle de parité du code LDPC correspondant à

$$t_{n,i} = \frac{c_i}{e_{n,i}^{(l)}} \qquad pour\ tous\ les\ i \in \mathcal{M}(n)$$

ou à une approximation de ceci, dans lequel $c_i$ représente une entrée d'une i-ième cellule de mémoire de la mémoire de nœud de contrôle (602), $e_{n,i}^{(l)}$ représente une entrée d'une cellule de mémoire de la mémoire extrinsèque (604) correspondant à une n-ième colonne et à une i-ème rangée de la matrice de contrôle de parité du code LDPC dans une 1-ième itération, et $\mathcal{M}(n)$ représente un ensemble de positions de uns dans la n-ième colonne de la matrice de contrôle de parité du code LDPC.

**5.** Décodeur (600) selon la revendication 4, dans lequel le décodeur LDPC stratifié en colonnes (122) est apte à fonctionner pour déterminer une sortie a posteriori correspondant à une n-ième colonne de la matrice de contrôle de parité du code LDPC correspondant à

$$v_n = \hat{z}_n + 2 \sum_{i \in \mathcal{M}(n)} \tanh^{-1}(t_{n,i})$$

ou à une approximation de ceci.

**6.** Décodeur (600) selon la revendication 5, dans lequel le décodeur LDPC stratifié en colonnes (122) est apte à fonctionner pour obtenir les informations de probabilité a priori mises à jour pour le décodeur différentiel (118) correspondant à une n-ième colonne de la matrice de contrôle de parité du code LDPC correspondant à $u_n = v_n - \hat{z}_n$ ou à une approximation de ceci.

**7.** Décodeur (600) selon la revendication 5, dans lequel le décodeur LDPC stratifié en colonnes (122) est apte à fonctionner pour déterminer une entrée mise à jour d'une cellule de mémoire de la mémoire extrinsèque (604) correspondant à une n-ième colonne et à une i-ème rangée de la matrice de contrôle de parité du code LDPC pour une (l+1)-ième itération du décodeur (600) correspondant à

$$e_{n,i}^{(l+1)} = \tanh\left(\frac{v_n - 2\tanh^{-1}(t_{n,i})}{2}\right)$$

ou à une approximation de ceci, et pour mettre à jour une i-ème cellule de mémoire de la mémoire de noeud de contrôle (602) correspondant à $c_i = e_{n,i} \cdot t_{n,i}$,
ou à une approximation de ceci.

**8.** Décodeur (600) selon la revendication 7, dans lequel une entrée $A_{i',j}$ de la i'-ème colonne et de la j-ème rangée de la matrice de transfert (A) est masquée si une entrée $A_{i,j}$ de la i-ème colonne et de la j-ème rangée de la matrice de transfert (A) diffère de la valeur prédéterminée, dans lequel une entrée masquée de la matrice de transfert (A) aboutit à une entrée vide dans la matrice de contrôle de parité (H) correspondante.

**9.** Décodeur (600) selon la revendication 7, dans lequel la matrice de transfert (A) est basée sur une super-matrice de transfert ($A_{super}$) comprenant des entrées x représentant un groupe de L entrées x adjacentes dans la matrice de transfert (A) et comprenant des entrées représentant un groupe de L entrées adjacentes différentes de x dans la matrice de transfert (A).

**10.** Procédé pour décoder de manière itérative un signal reçu généré par le codage d'un mot de code LDPC avec un code différentiel, le procédé comprenant :

le décodage différentiel du signal reçu pour fournir des informations de probabilité extrinsèque sur le mot de code LDPC sur la base d'informations de probabilité a priori sur le signal reçu ;
le décodage du mot de code LDPC par le traitement de colonnes de la matrice de contrôle de parité du code LDPC sur la base des informations de probabilité extrinsèque fournies pour obtenir des informations de probabilité a priori mises à jour pour une itération suivante de décodage différentiel ;
dans lequel le décodeur LDPC stratifié en colonnes (122) est apte à fonctionner pour traiter S colonnes de la matrice de contrôle de parité du code LDPC (H) en parallèle, dans lequel la matrice de contrôle de parité du code LDPC (H) est construite à partir d'une matrice de transfert A par le replacement de chaque entrée de la matrice de transfert (A) avec soit une matrice remplie de zéros de taille SxS soit une matrice de permutation de taille SxS soit une superposition de multiples matrices de permutation de taille SxS, en fonction de l'entrée de A, et
dans lequel une entrée $A_{i',j}$ de la i'-ème colonne et de la j-ème rangée de la matrice de transfert (A) est x si une entrée $A_{i,j}$ de la i-ème colonne et de la j-ème rangée de la matrice de transfert A est x, dans lequel x représente une valeur prédéterminée conduisant à des entrées vides dans la matrice de contrôle de parité du code LDPC (H) correspondante, et dans lequel i = 1, 1+L, 1+2L, ... et i' = i+1, i+2, ..., i+L-1, L étant un nombre entier.

**11.** Programme d'ordinateur ayant un code de programme pour réaliser le procédé selon la revendication 10, lorsque le programme d'ordinateur est exécuté sur un ordinateur ou un processeur.

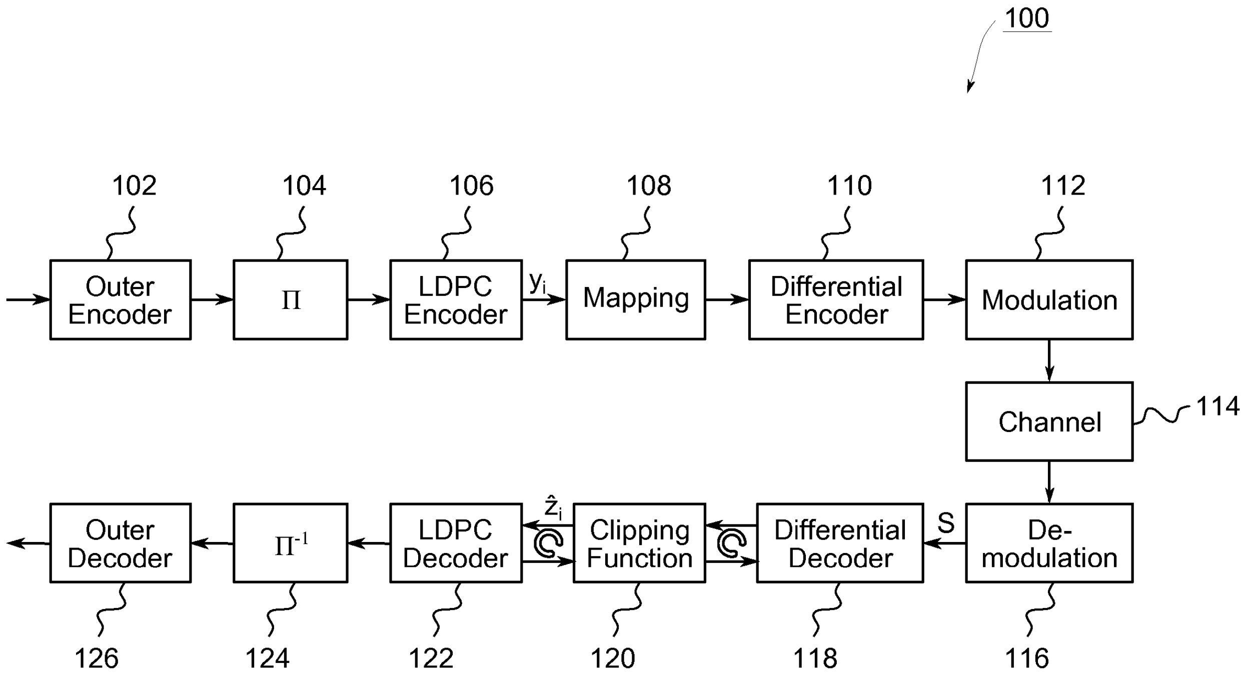
100
102
104
106
108
110
112
Outer Encoder
Π
LDPC Encoder
$y_i$
Mapping
Differential Encoder
Modulation
Channel
114
Outer Decoder
$\Pi^{-1}$
LDPC Decoder
$\hat{z}_i$
Clipping Function
Differential Decoder
S
De-modulation
126
124
122
120
118
116

Fig. 1

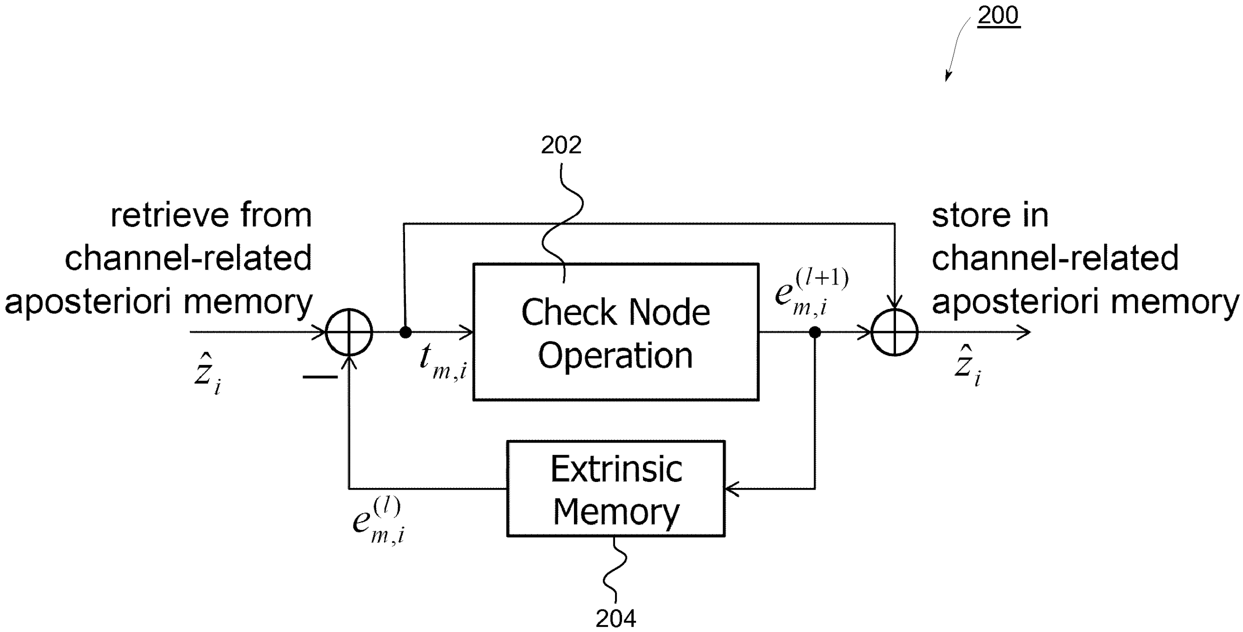
200
202
retrieve from channel-related aposteriori memory
$\hat{z}_i$
—
$t_{m,i}$
Check Node Operation
$e_{m,i}^{(l+1)}$
store in channel-related aposteriori memory
$\hat{z}_i$
Extrinsic Memory
$e_{m,i}^{(l)}$
204

Fig. 2

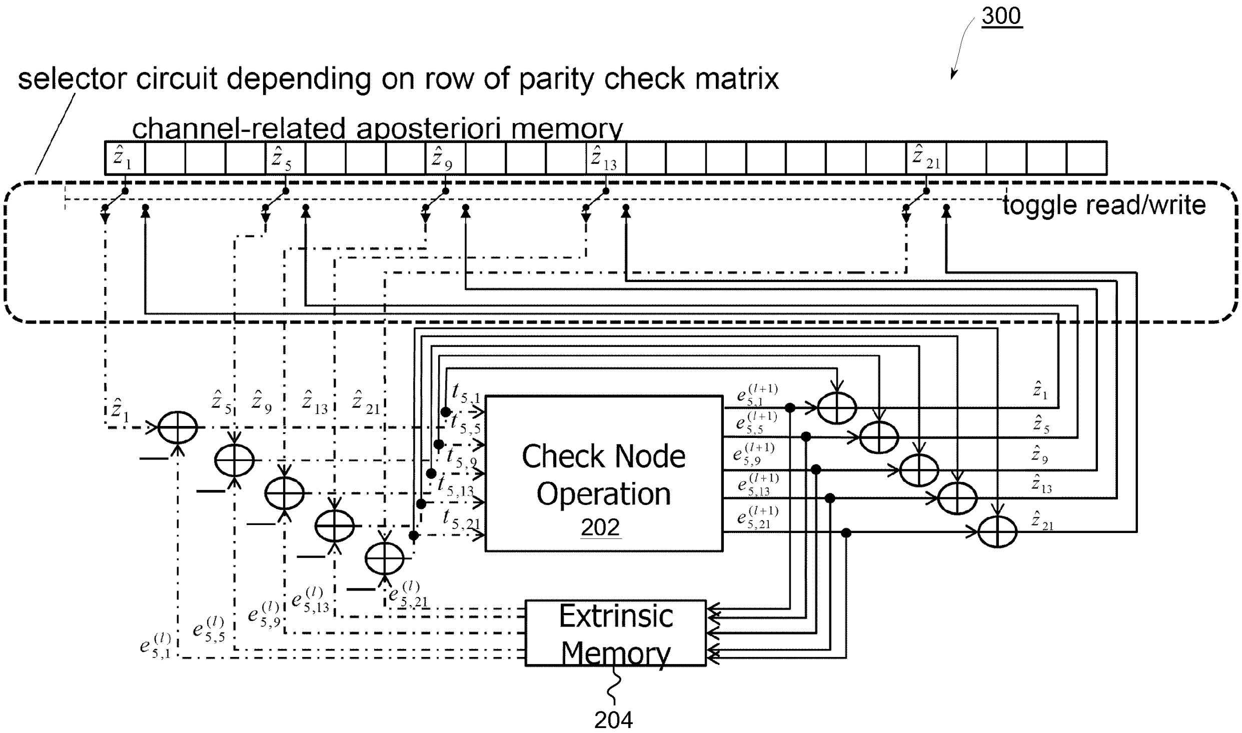
300
selector circuit depending on row of parity check matrix
channel-related aposteriori memory
toggle read/write
Check Node Operation
202
Extrinsic Memory
204

Fig. 3

400

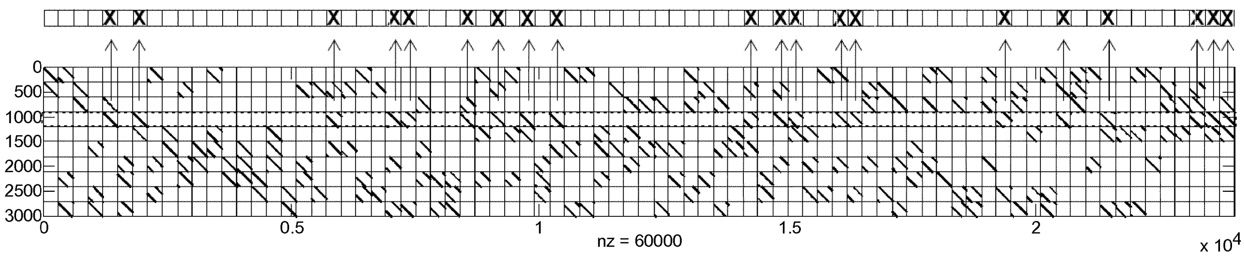


Fig. 4

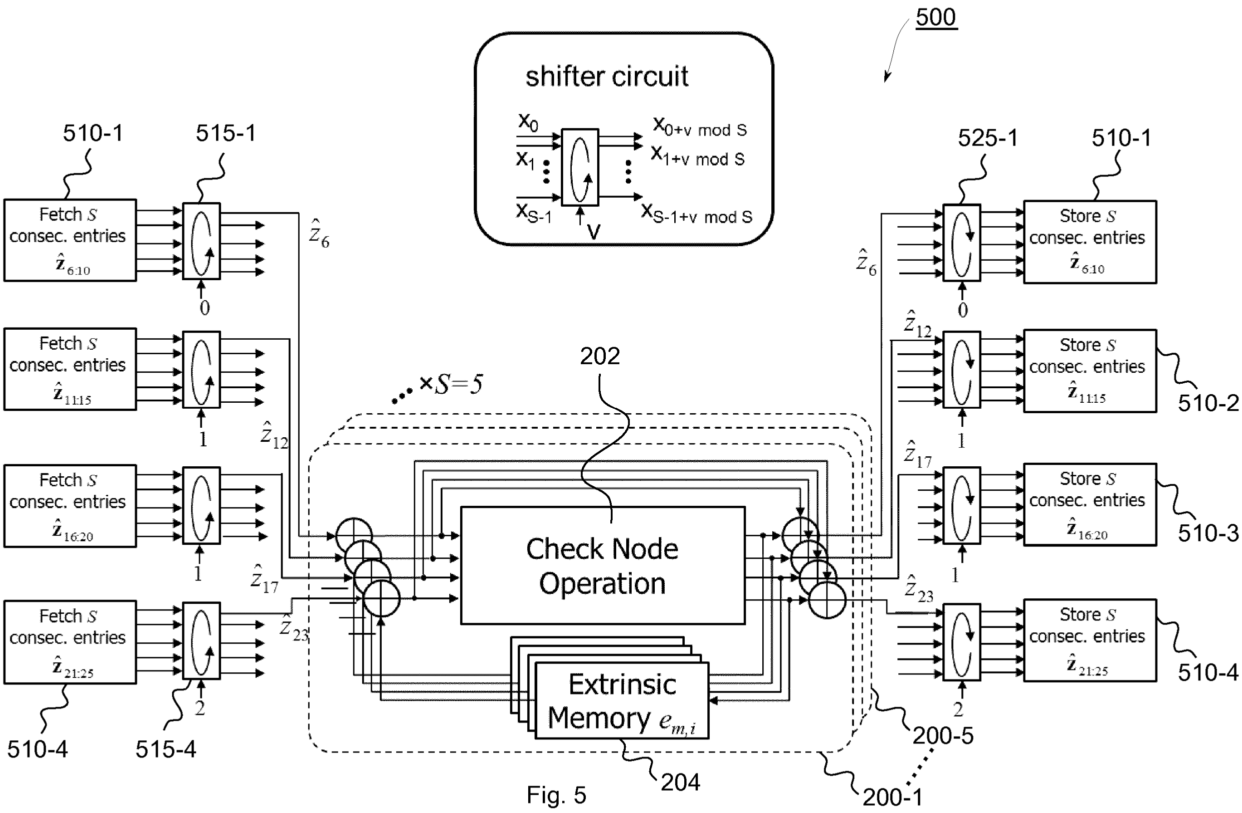
500
shifter circuit
$x_0$
$x_1$
$x_{S-1}$
v
$x_{0+v \bmod S}$
$x_{1+v \bmod S}$
$x_{S-1+v \bmod S}$
510-1
515-1
Fetch S consec. entries $\hat{z}_{6:10}$
Fetch S consec. entries $\hat{z}_{11:15}$
Fetch S consec. entries $\hat{z}_{16:20}$
Fetch S consec. entries $\hat{z}_{21:25}$
0
1
1
2
510-4
515-4
$\hat{z}_6$
$\hat{z}_{12}$
$\hat{z}_{17}$
$\hat{z}_{23}$
×S=5
202
Check Node Operation
Extrinsic Memory $e_{m,i}$
204
200-5
200-1
525-1
510-1
Store S consec. entries $\hat{z}_{6:10}$
Store S consec. entries $\hat{z}_{11:15}$
Store S consec. entries $\hat{z}_{16:20}$
Store S consec. entries $\hat{z}_{21:25}$
510-2
510-3
510-4
Fig. 5

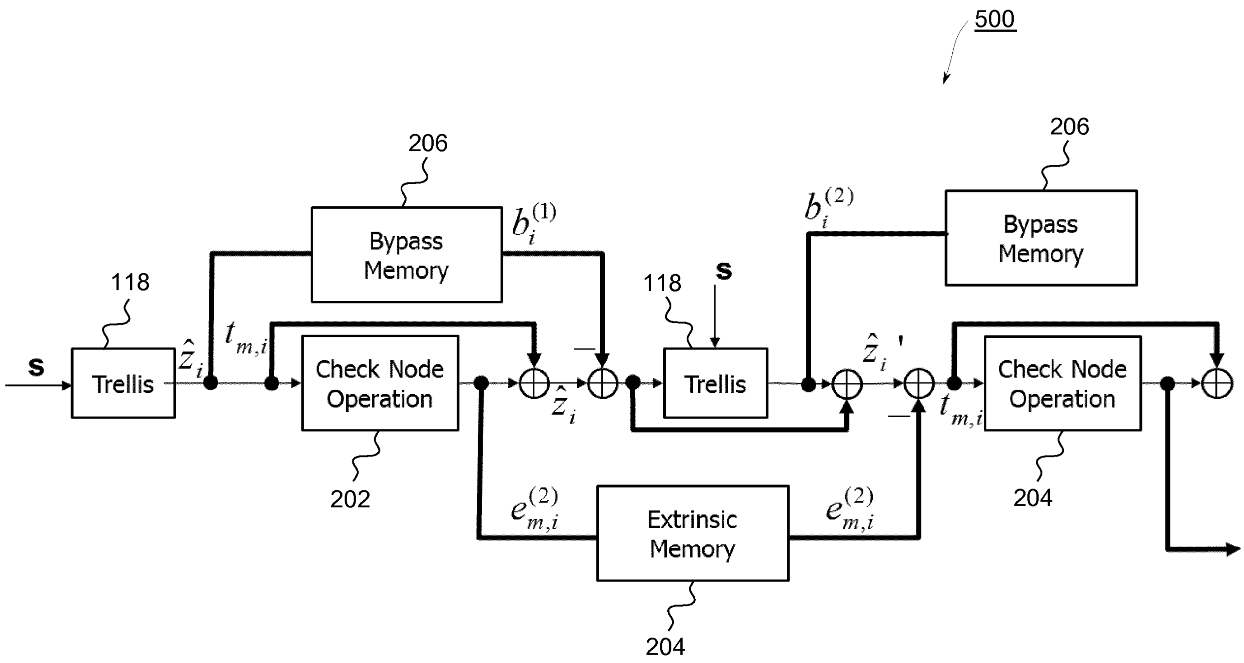
500
206
Bypass Memory
$b_i^{(1)}$
118
s
Trellis
$\hat{z}_i$
$t_{m,i}$
Check Node Operation
202
$\hat{z}_i$
118
s
Trellis
$b_i^{(2)}$
206
Bypass Memory
$\hat{z}_i$'
$t_{m,i}$
Check Node Operation
204
$e_{m,i}^{(2)}$
Extrinsic Memory
$e_{m,i}^{(2)}$
204

Fig. 5a

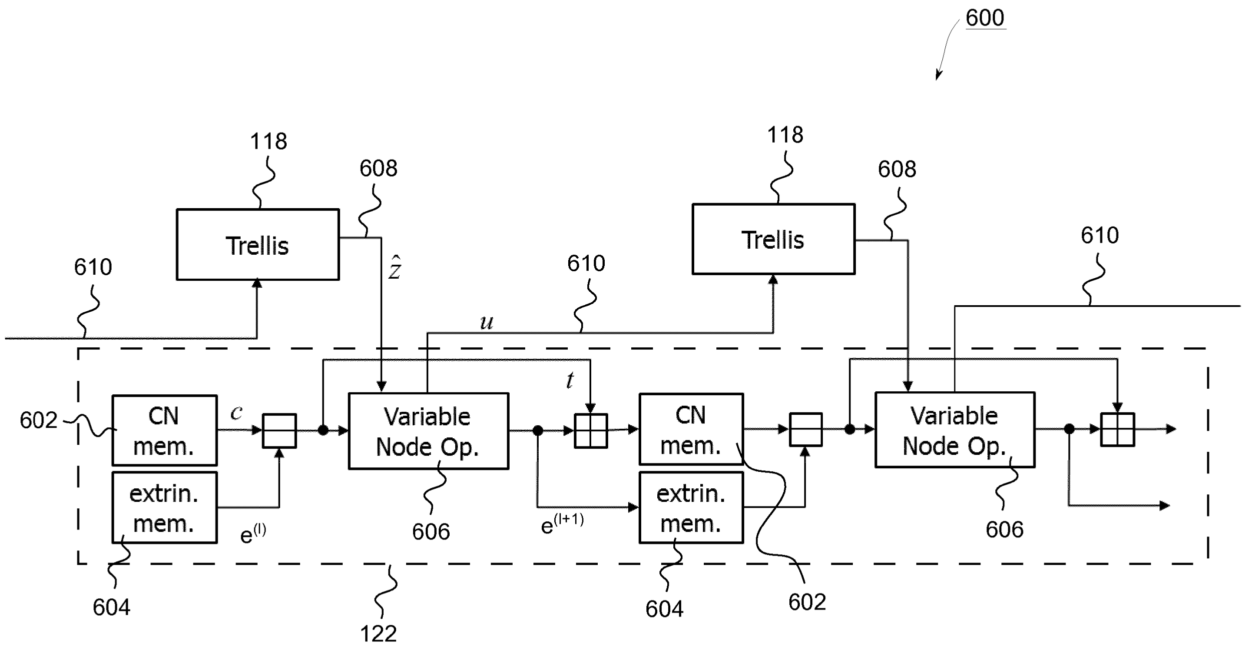
600
118
608
Trellis
610
ẑ
u
118
608
Trellis
610
610
602
CN mem.
c
extrin. mem.
e(l)
Variable Node Op.
t
606
e(l+1)
CN mem.
extrin. mem.
604
Variable Node Op.
606
604
122
604
602

Fig. 6

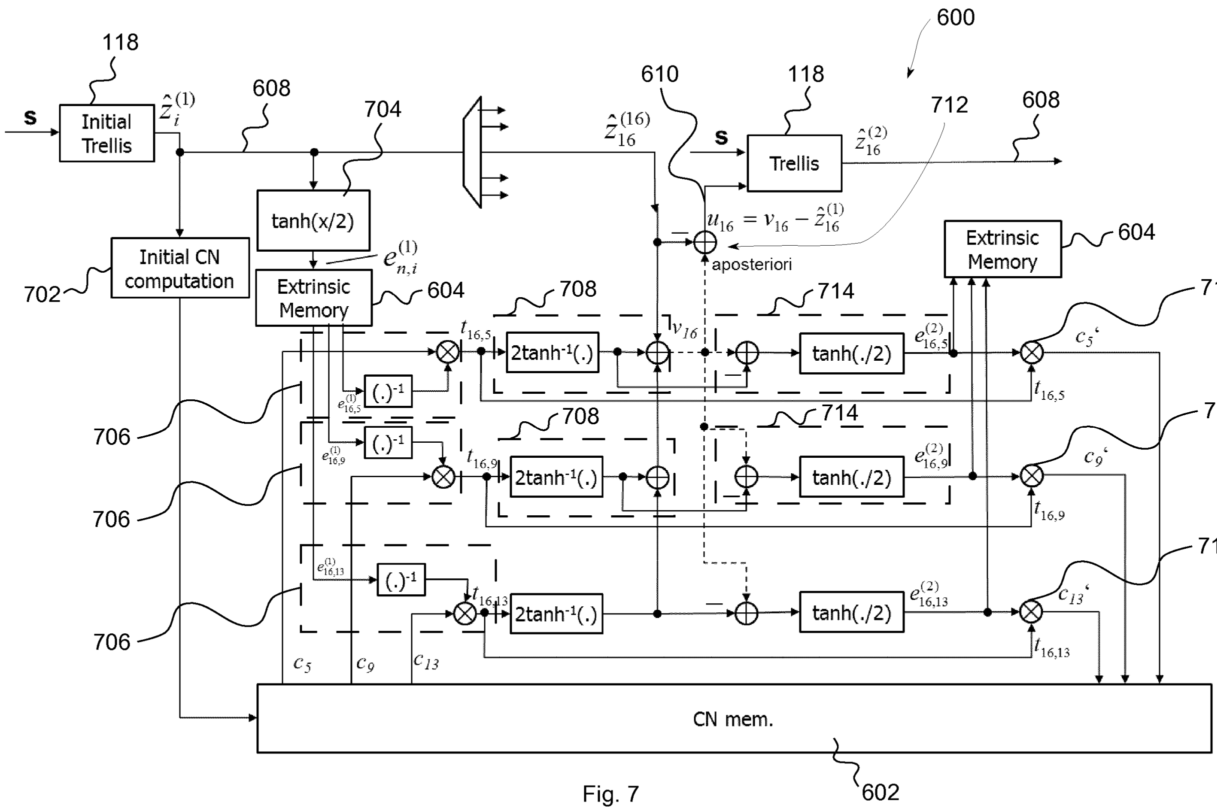
600
118
s
Initial Trellis
608
704
610
118
712
608
s
Trellis
tanh(x/2)
Initial CN computation
702
Extrinsic Memory
604
708
714
Extrinsic Memory
604
716
aposteriori
2tanh⁻¹(.)
tanh(./2)
(.)⁻¹
706
708
714
716
706
706
716
CN mem.
602

Fig. 7

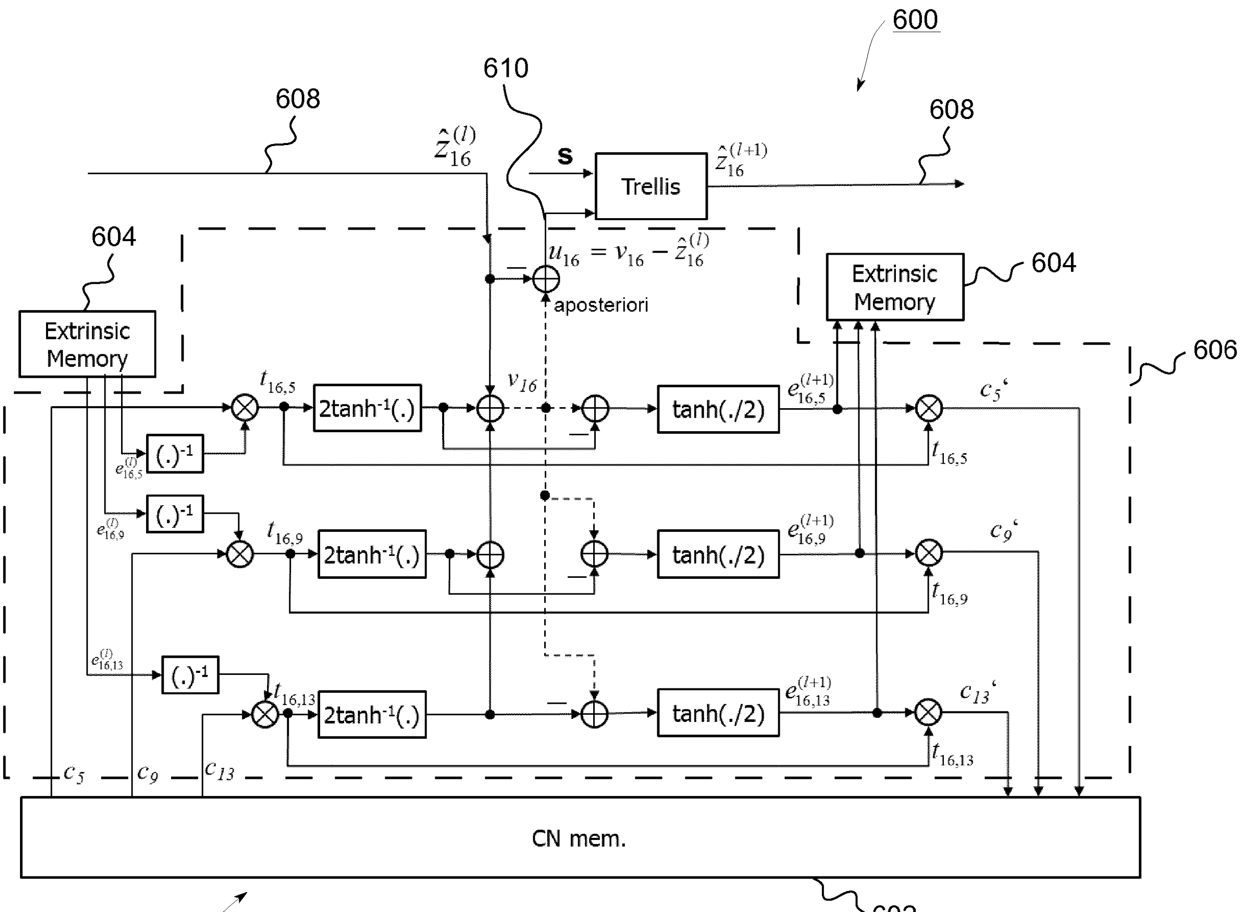

600
610
608
608
604
604
606
Trellis
s
Extrinsic Memory
Extrinsic Memory
aposteriori
2tanh-1(.)
tanh(./2)
(.)-1
CN mem.
602
122


Fig. 8

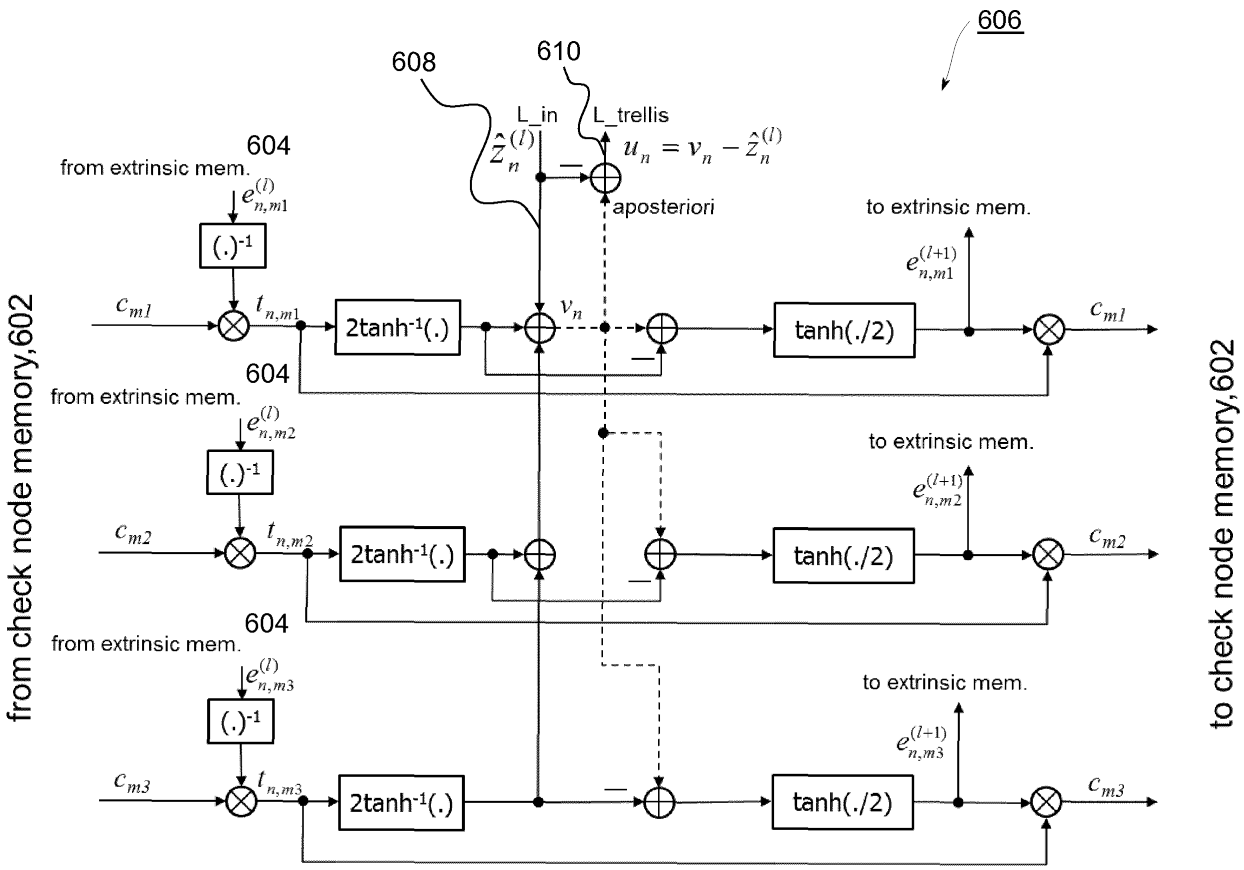
606
608
610
L_in
L_trellis
$u_n = v_n - \hat{z}_n^{(l)}$
aposteriori
604
from extrinsic mem.
to extrinsic mem.
from check node memory,602
to check node memory,602
(.)-1
2tanh-1(.)
tanh(./2)


Fig. 8a

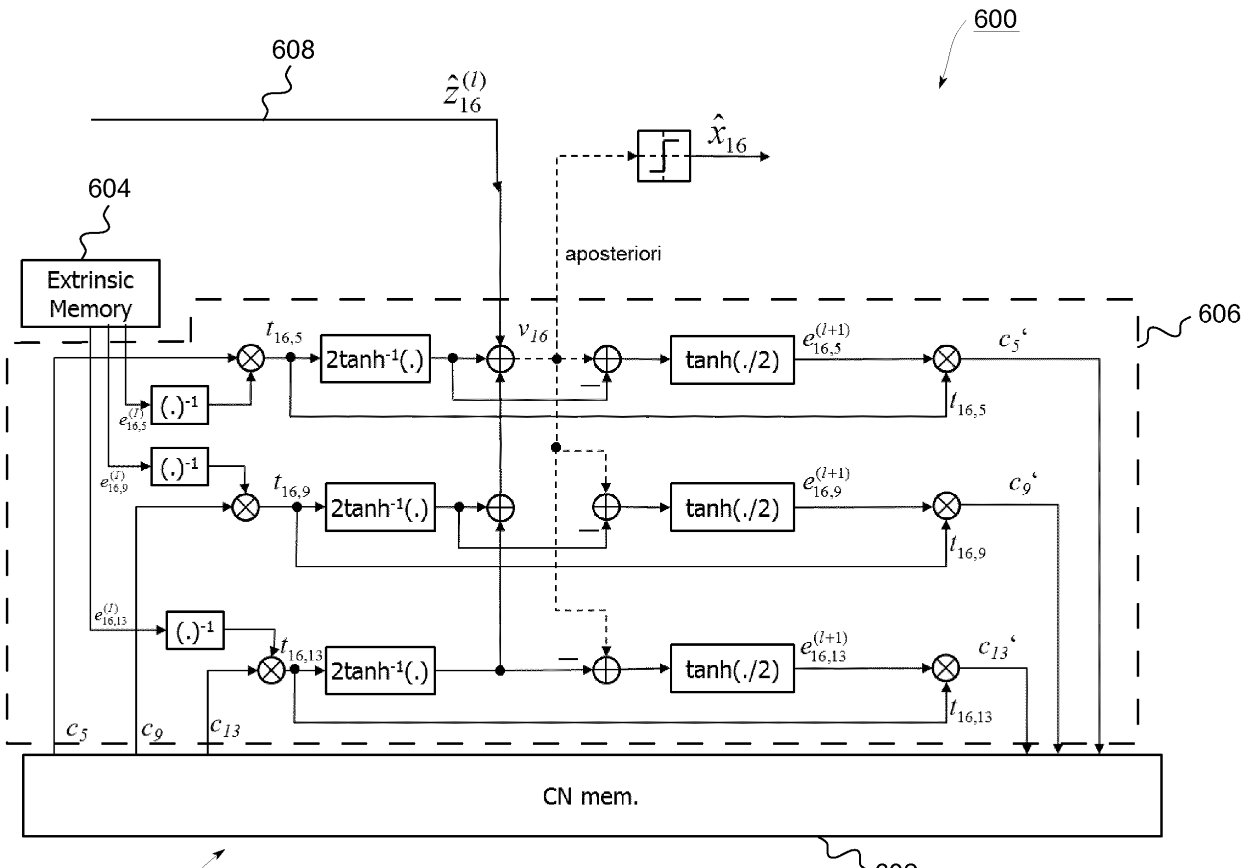
600
608
604
606
602
122
Extrinsic Memory
CN mem.
aposteriori
2tanh-1(.)
tanh(./2)
(.)-1
$\hat{z}_{16}^{(l)}$
$\hat{x}_{16}$
$v_{16}$
$t_{16,5}$
$t_{16,9}$
$t_{16,13}$
$e_{16,5}^{(l+1)}$
$e_{16,9}^{(l+1)}$
$e_{16,13}^{(l+1)}$
$c_5$'
$c_9$'
$c_{13}$'
$c_5$
$c_9$
$c_{13}$

Fig. 9

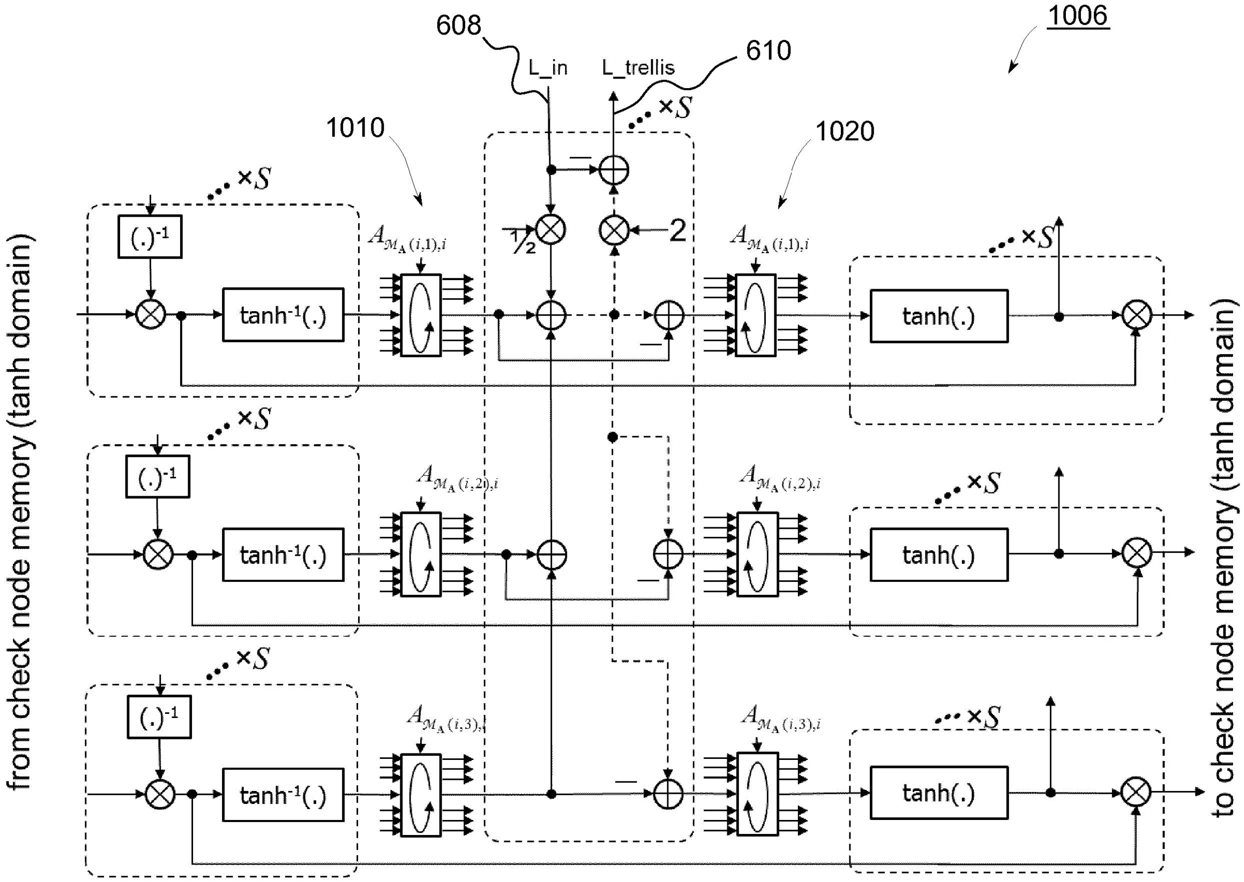
1006
608
610
L_in
L_trellis
1010
1020
×S
(.)-1
tanh-1(.)
tanh(.)
½
2
from check node memory (tanh domain)
to check node memory (tanh domain)

Fig. 10

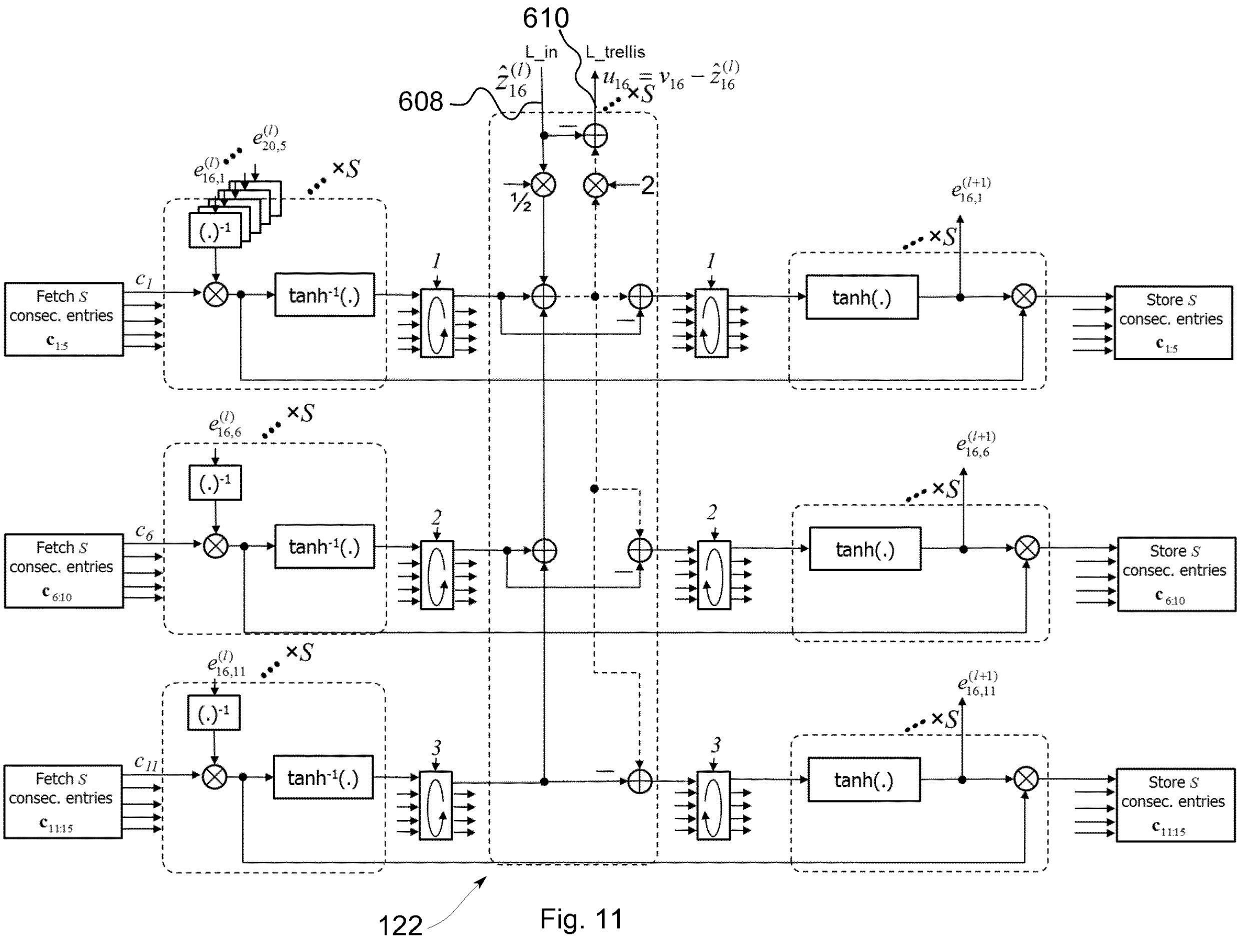
610
608
L_in
L_trellis
$\hat{z}_{16}^{(l)}$
$u_{16} = v_{16} - \hat{z}_{16}^{(l)}$
×S
½
2
$e_{16,1}^{(l)}$
$e_{20,5}^{(l)}$
(.)⁻¹
Fetch S consec. entries $\mathbf{c}_{1:5}$
$c_1$
tanh⁻¹(.)
1
tanh(.)
$e_{16,1}^{(l+1)}$
Store S consec. entries $\mathbf{c}_{1:5}$
$e_{16,6}^{(l)}$
Fetch S consec. entries $\mathbf{c}_{6:10}$
$c_6$
2
$e_{16,6}^{(l+1)}$
Store S consec. entries $\mathbf{c}_{6:10}$
$e_{16,11}^{(l)}$
Fetch S consec. entries $\mathbf{c}_{11:15}$
$c_{11}$
3
$e_{16,11}^{(l+1)}$
Store S consec. entries $\mathbf{c}_{11:15}$
122

Fig. 11

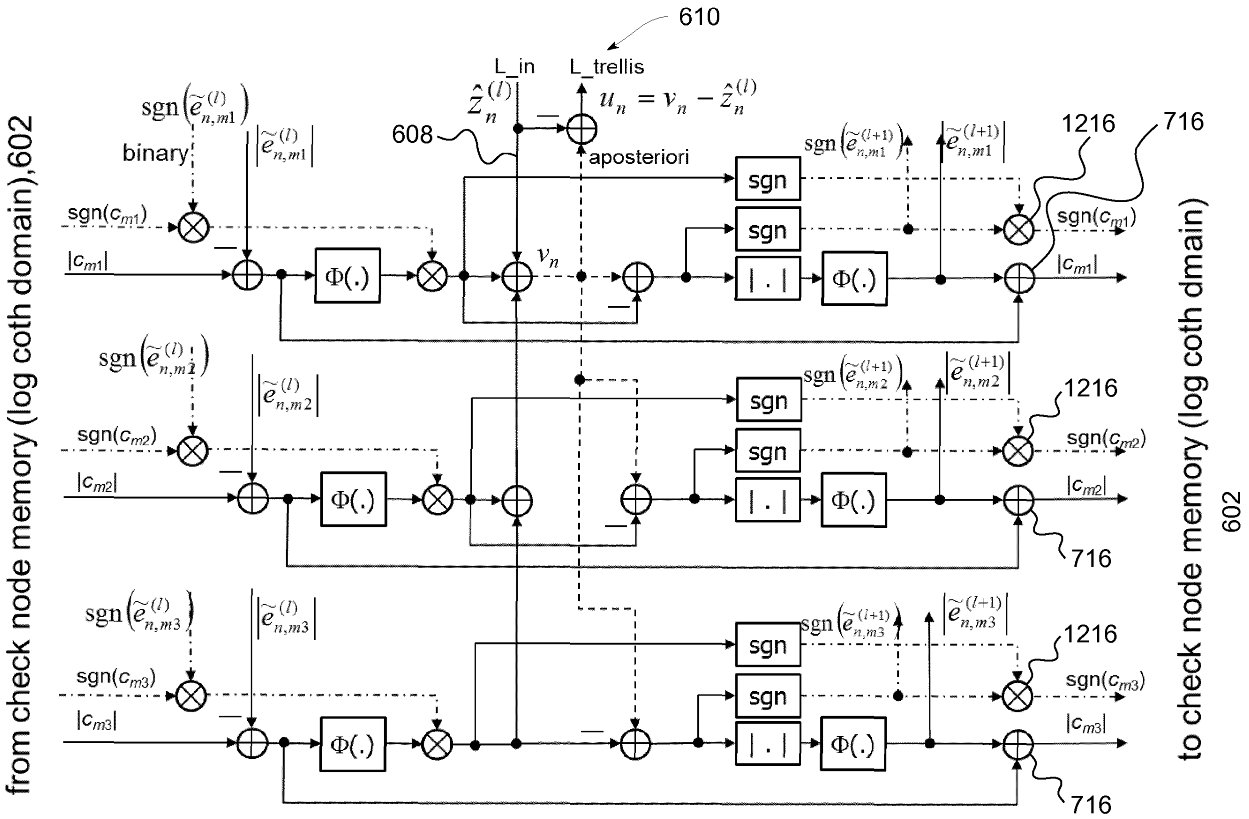

610
L_in
L_trellis
$u_n = v_n - \hat{z}_n^{(l)}$
$\hat{z}_n^{(l)}$
608
aposteriori
from check node memory (log coth domain),602
to check node memory (log coth dmain)
602
binary
sgn($c_{m1}$)
$|c_{m1}|$
sgn($c_{m2}$)
$|c_{m2}|$
sgn($c_{m3}$)
$|c_{m3}|$
Φ(.)
sgn
| . |
$v_n$
1216
716


Fig. 12

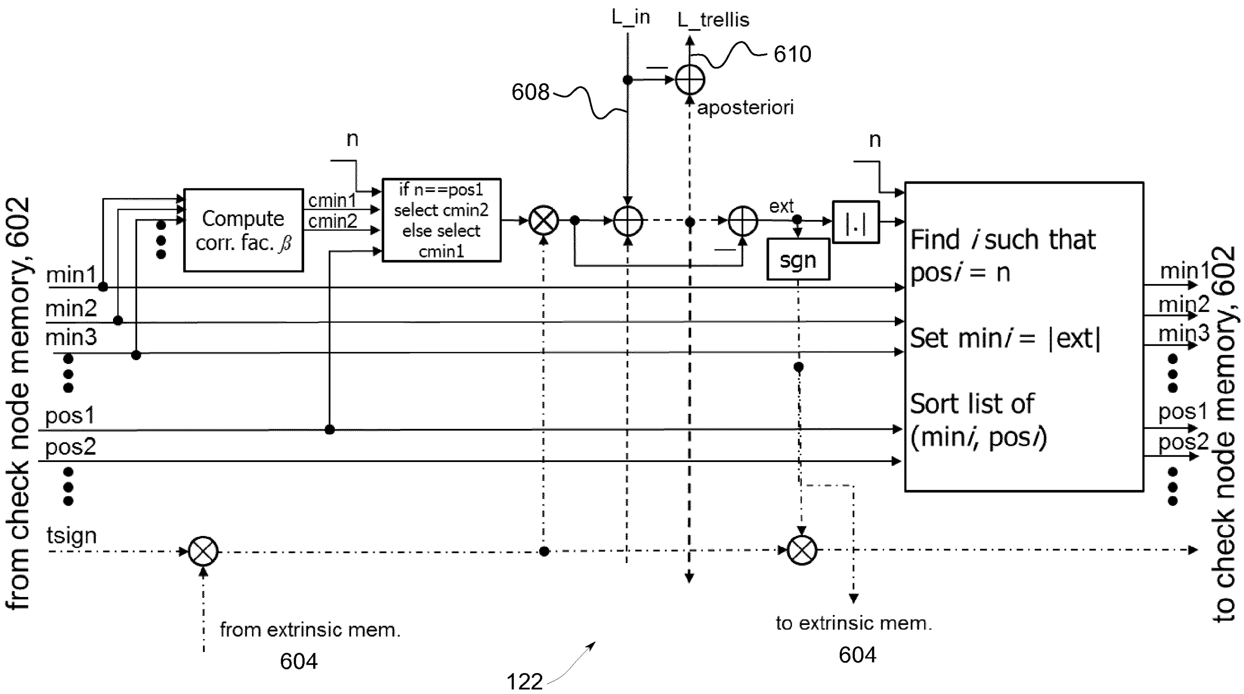

L_in
L_trellis
610
608
aposteriori
n
n
Compute
corr. fac. β
cmin1
cmin2
if n==pos1
select cmin2
else select
cmin1
ext
|.|
sgn
Find i such that
pos i = n
Set min i = |ext|
Sort list of
(min i, pos i)
from check node memory, 602
min1
min2
min3
pos1
pos2
tsign
min1
min2
min3
pos1
pos2
to check node memory, 602
from extrinsic mem.
604
to extrinsic mem.
604
122


Fig. 13

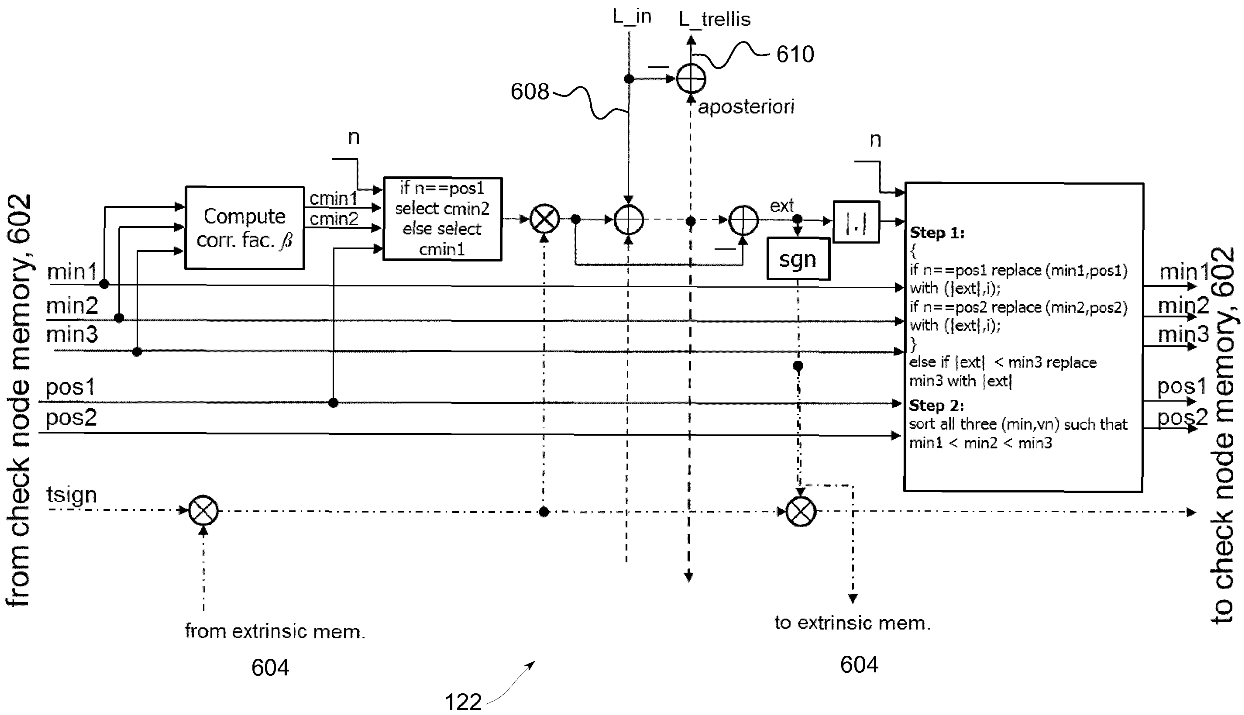

L_in
L_trellis
610
608
aposteriori
n
n
Compute corr. fac. β
cmin1
cmin2
if n==pos1 select cmin2 else select cmin1
ext
|.|
sgn
Step 1:
{
if n==pos1 replace (min1,pos1) with (|ext|,i);
if n==pos2 replace (min2,pos2) with (|ext|,i);
}
else if |ext| < min3 replace min3 with |ext|
Step 2:
sort all three (min,vn) such that min1 < min2 < min3
from check node memory, 602
min1
min2
min3
pos1
pos2
tsign
min1
min2
min3
pos1
pos2
to check node memory, 602
from extrinsic mem.
604
to extrinsic mem.
604
122

Fig. 14

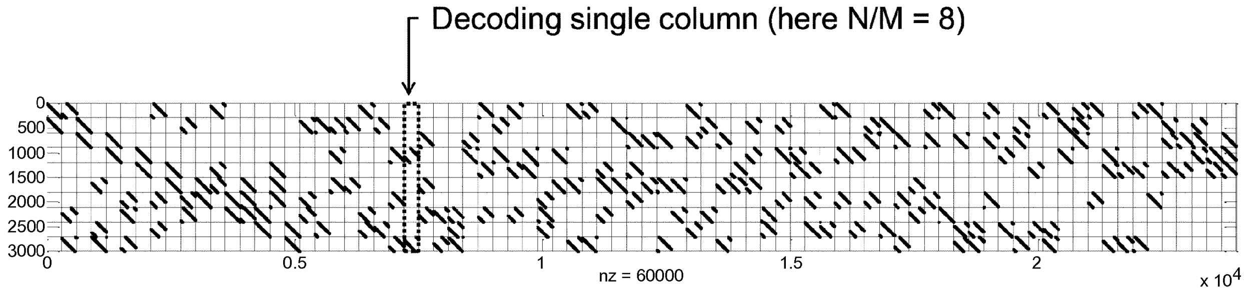


Fig. 15a

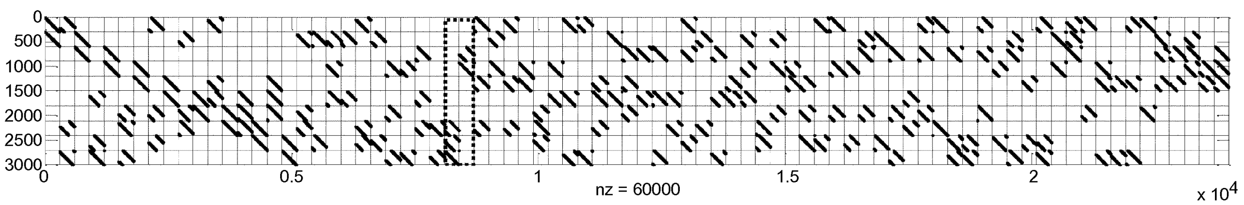


Fig. 15b

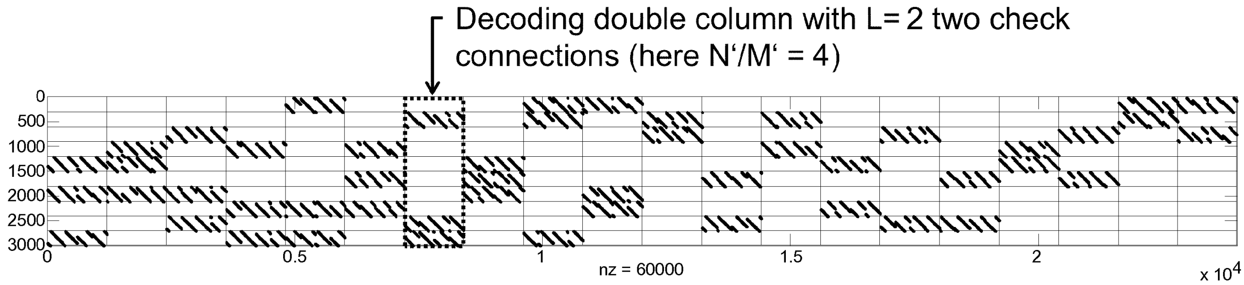


Fig. 16a

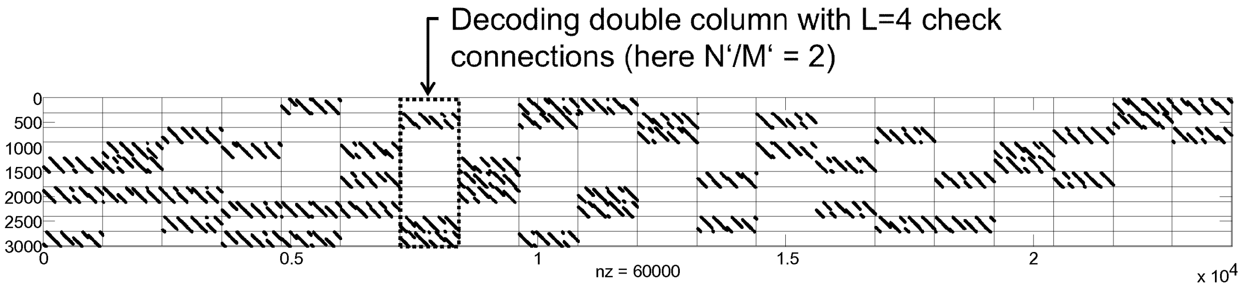


Fig. 16b

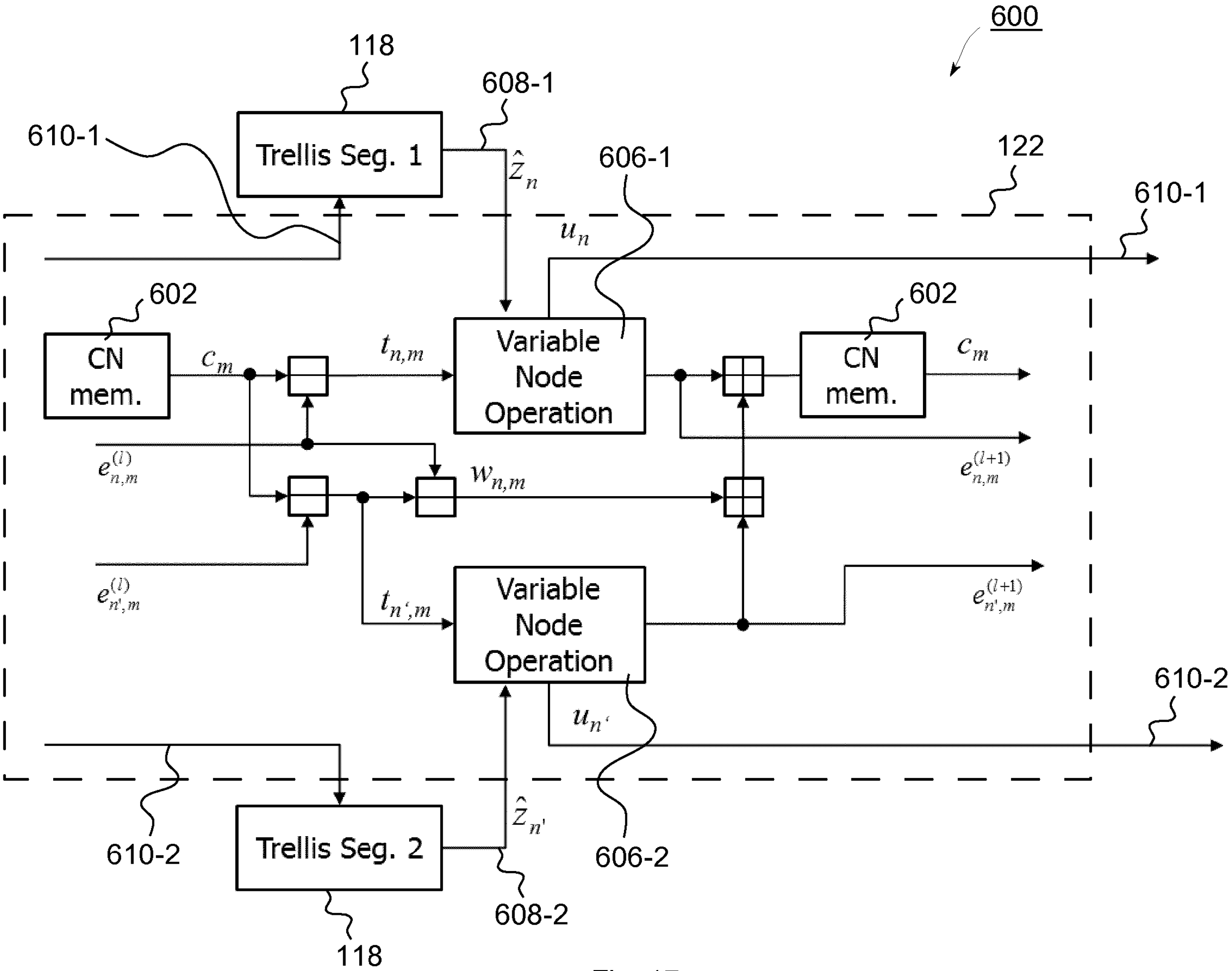
600
118
608-1
610-1
Trellis Seg. 1
$\hat{z}_n$
606-1
122
610-1
$u_n$
602
602
CN mem.
$c_m$
$t_{n,m}$
Variable Node Operation
CN mem.
$c_m$
$e_{n,m}^{(l)}$
$w_{n,m}$
$e_{n,m}^{(l+1)}$
$e_{n',m}^{(l)}$
$t_{n',m}$
Variable Node Operation
$e_{n',m}^{(l+1)}$
610-2
$u_{n'}$
610-2
Trellis Seg. 2
$\hat{z}_{n'}$
606-2
608-2
118

Fig. 17

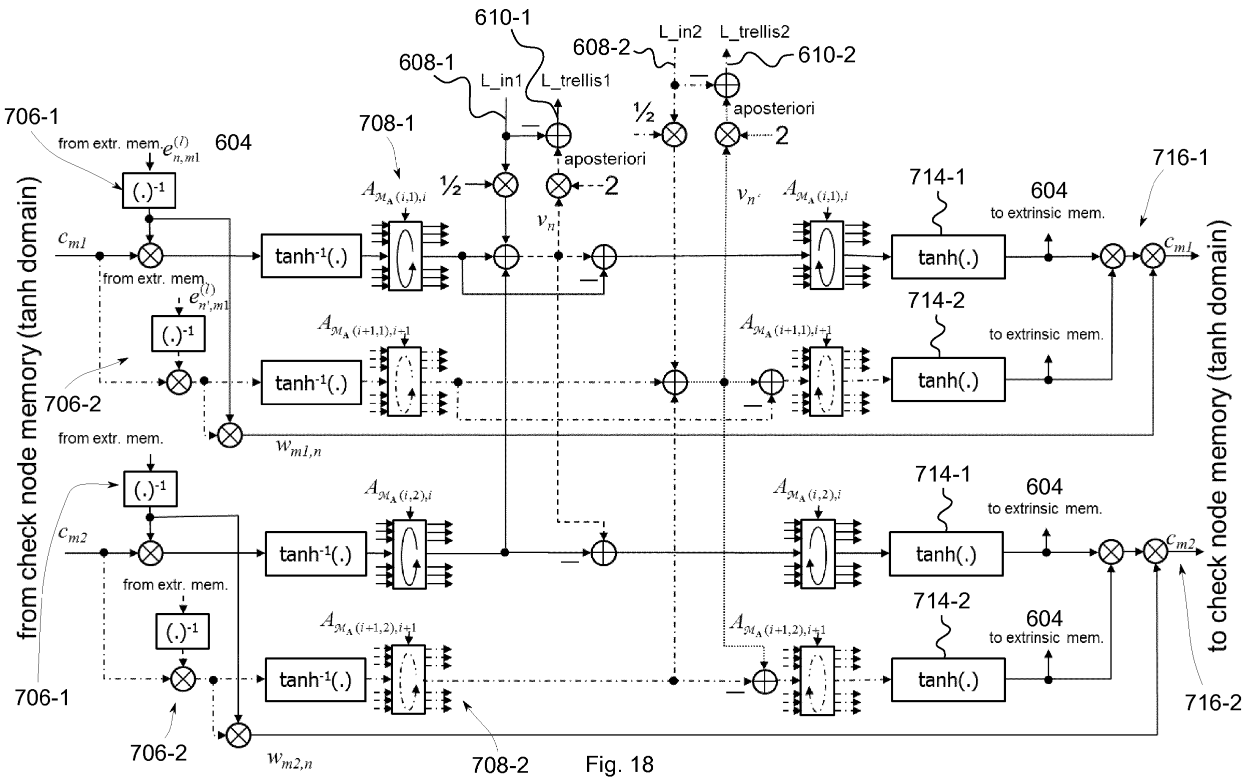
610-1
608-2
L_in2
L_trellis2
610-2
608-1
L_in1
L_trellis1
aposteriori
706-1
from extr. mem.
604
708-1
½
2
aposteriori
716-1
714-1
604
to extrinsic mem.
from check node memory (tanh domain)
tanh⁻¹(.)
tanh(.)
from extr. mem.
714-2
to extrinsic mem.
706-2
from extr. mem.
714-1
604
to extrinsic mem.
to check node memory (tanh domain)
714-2
604
to extrinsic mem.
from extr. mem.
706-1
716-2
706-2
708-2

Fig. 18

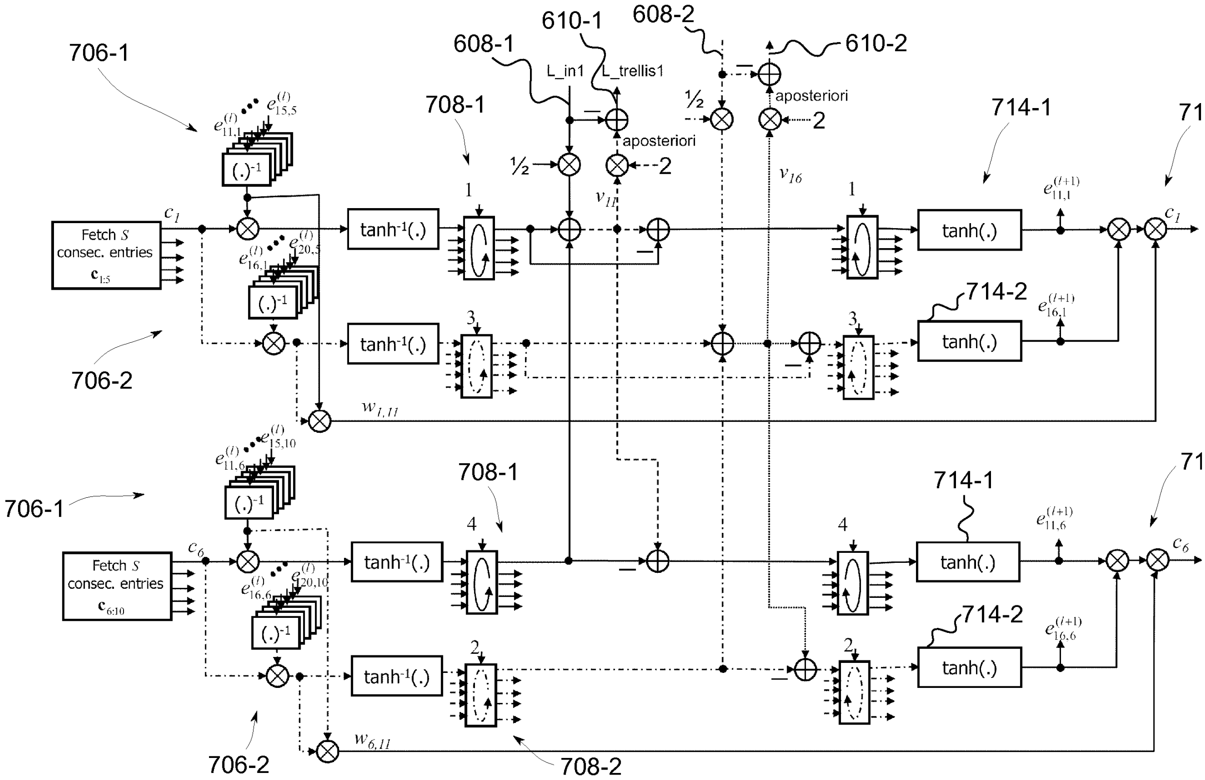
706-1
608-1
610-1
608-2
610-2
L_in1
L_trellis1
708-1
aposteriori
½
2
714-1
716-1
Fetch S consec. entries
tanh⁻¹(.)
tanh(.)
(.)⁻¹
706-2
714-2
708-2
716-2
v11
v16
w1,11
w6,11
c1
c6

Fig. 18a

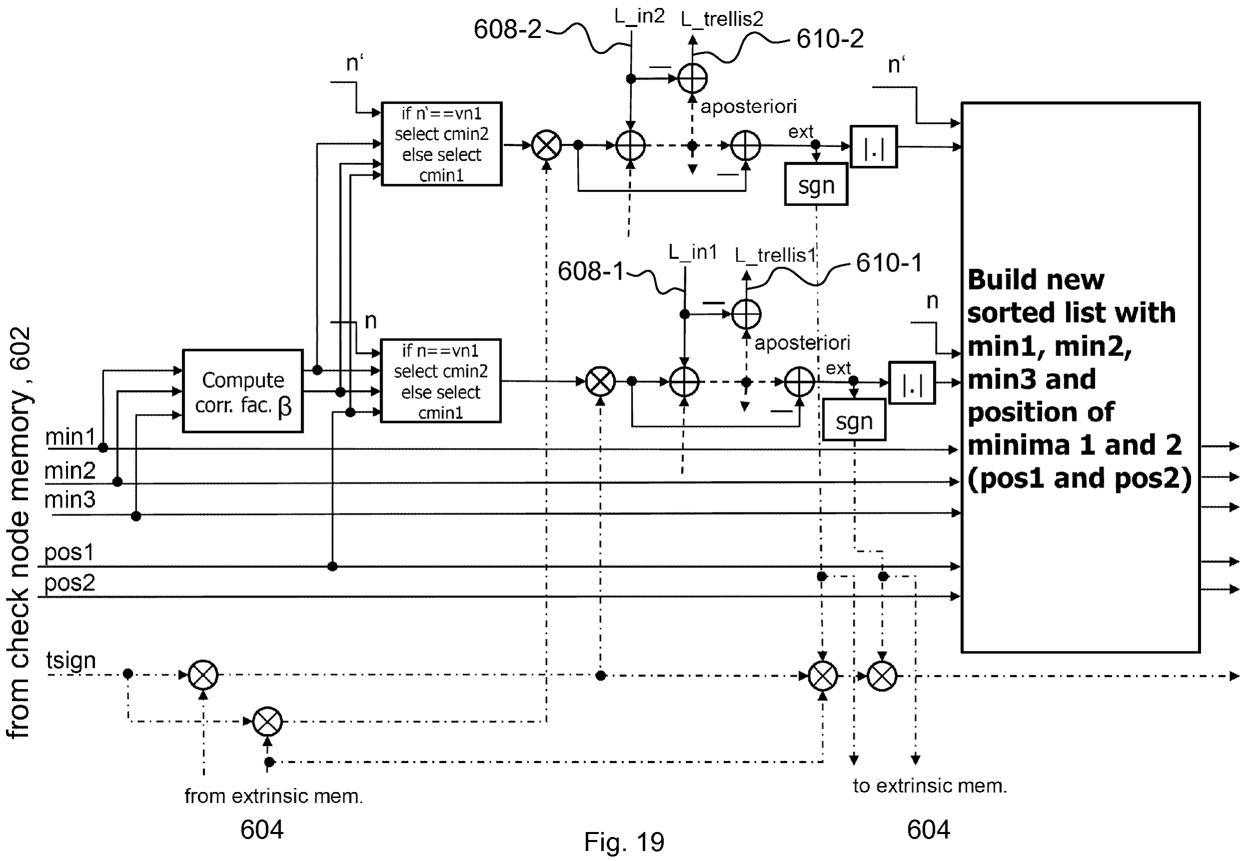
608-2
L_in2
L_trellis2
610-2
n'
n'
if n'==vn1 select cmin2 else select cmin1
aposteriori
ext
|.|
sgn
608-1
L_in1
L_trellis1
610-1
n
n
Compute corr. fac. β
if n==vn1 select cmin2 else select cmin1
aposteriori
ext
|.|
sgn
Build new sorted list with min1, min2, min3 and position of minima 1 and 2 (pos1 and pos2)
from check node memory, 602
min1
min2
min3
pos1
pos2
tsign
from extrinsic mem.
604
to extrinsic mem.
604

Fig. 19

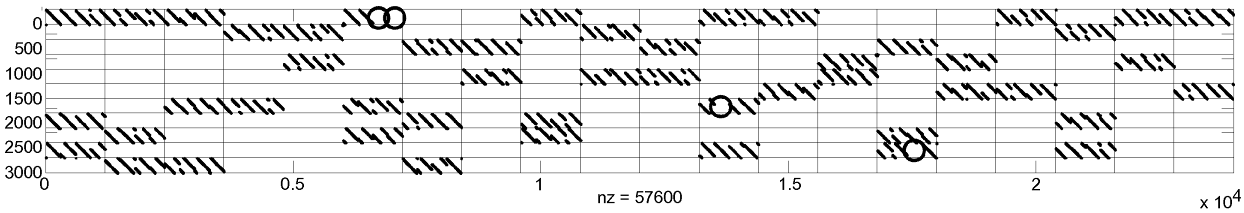
0
500
1000
1500
2000
2500
3000
0
0.5
1
1.5
2
nz = 57600
x 10^4

Fig. 20

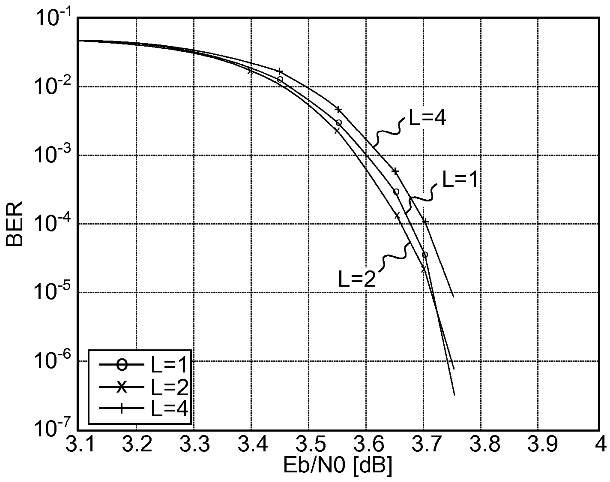
10^-1
10^-2
10^-3
10^-4
10^-5
10^-6
10^-7
BER
3.1 3.2 3.3 3.4 3.5 3.6 3.7 3.8 3.9 4
Eb/N0 [dB]
L=4
L=1
L=2
L=1
L=2
L=4

Fig. 21

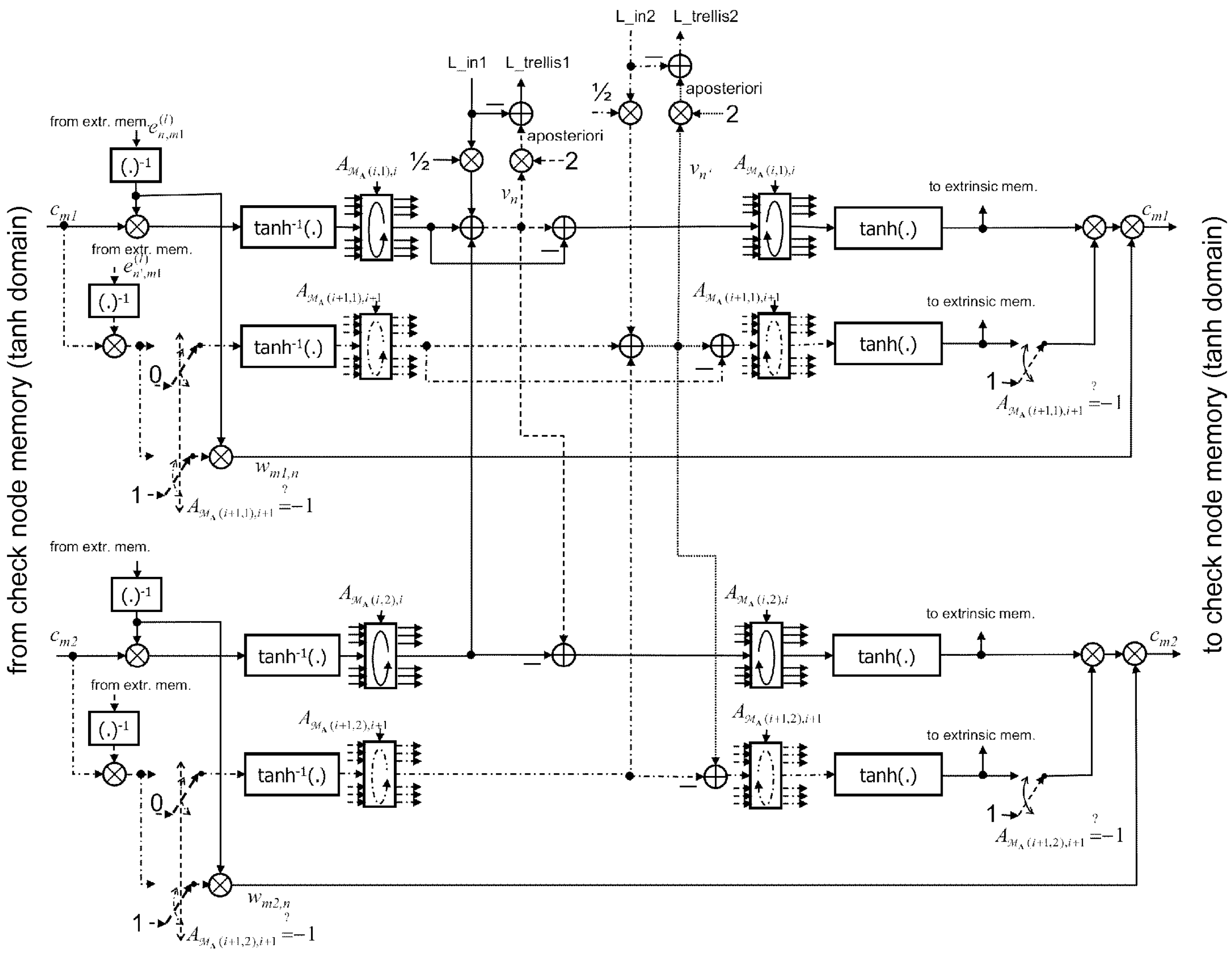
L_in2 L_trellis2
L_in1 L_trellis1
½
aposteriori
2
-2
from extr. mem.
(.)-1
tanh-1(.)
tanh(.)
to extrinsic mem.
from check node memory (tanh domain)
to check node memory (tanh domain)
0
1

Fig. 20a

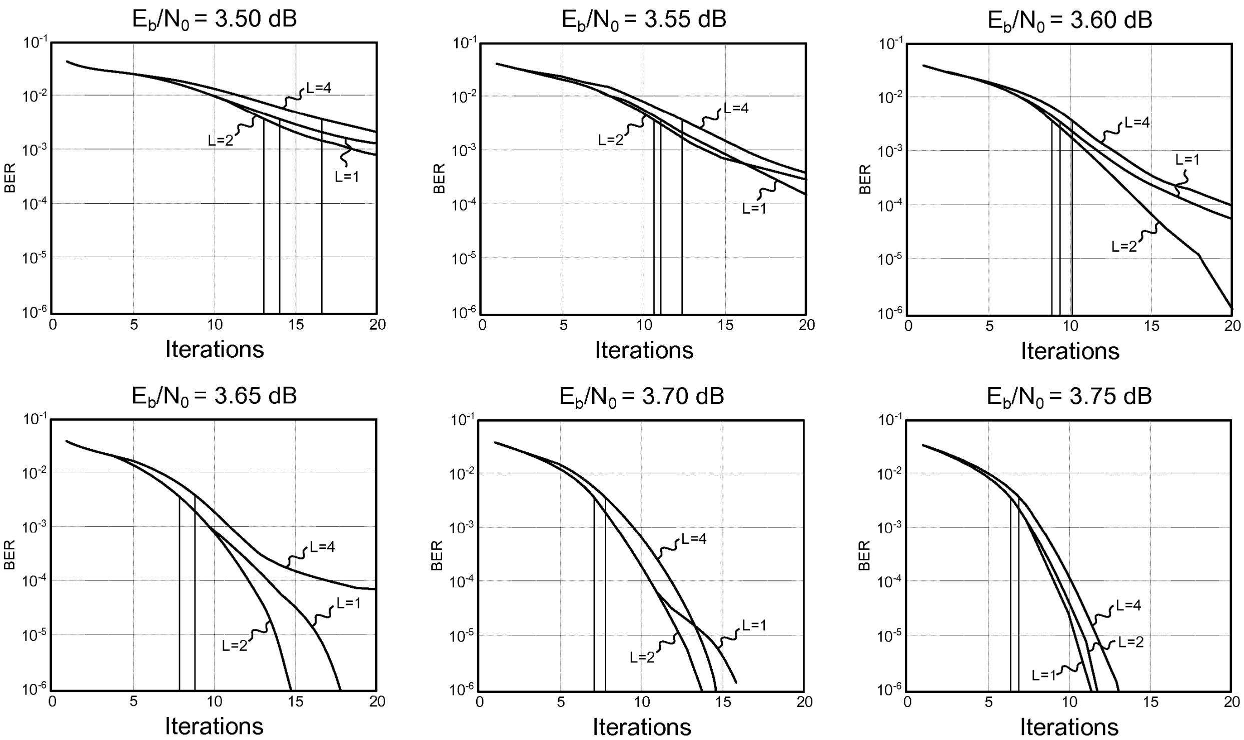
Eb/N0 = 3.50 dB
Eb/N0 = 3.55 dB
Eb/N0 = 3.60 dB
Eb/N0 = 3.65 dB
Eb/N0 = 3.70 dB
Eb/N0 = 3.75 dB
BER
Iterations
L=1
L=2
L=4

Fig. 22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2538596 A1


### Non-patent literature cited in the description


- Concatenated eIRA Codes for Tamed Frequency Modulation. **JIANRONG BAO et al.** IEEE INTERNATIONAL CONFERENCE ON COMMUNICATIONS. ICC, 2008, 1886-1891
- **D. E. HOCEVAR.** A Reduced Complexity Decoder Architecture via Layered Decoding of LDPC Codes. *Proc. IEEE Workshop on Signal Processing Systems (SIPS),* 2004
- **J. CHEN ; A. DHOLAKIA ; E. ELEFTHERIOU ; M. P. C. FOSSORIER ; X.-Y. HU.** Reduced-Complexity Decoding of LDPC Codes. *IEEE Transactions on Communications,* August 2005, vol. 53 (8), 1288-1299
- **L. R. BAHL ; J. COCKE ; F. JELINEK ; J. RAVIV.** Optimal Decoding of Linear Codes for minimizing symbol error rate. *IEEE Transactions on Information Theory,* March 1974, vol. IT-20 (2), 284-287
- **J. HAGENAUER ; E. OFFER ; L. PAPKE.** Iterative Decoding of Binary Block and Convolutional Codes. *IEEE Trans. Inform. Theory,* March 1996, vol. 42 (2
- **Z. CUI ; Z. WANG ; X. ZHANG.** Reduced-Complexity Column-Layered Decoding and Implementation for LDPC Codes. *IET Communications, where an efficient hardware implementation was presented*
- **Z. CUI ; Z. WANG ; X. ZHANG.** Reduced-Complexity Column-Layered Decoding and Implementation for LDPC Codes. *IET Communications only deals with the pure LDPC decoding hardware architecture and does not contain any demodulator or differential decoder 118 in the iterative loop. In addition to that*
- **M. LI ; C. A. NOUR ; C. JÉGO ; J. YANG ; C. DOUILLARD.** A shuffled iterative bit-interleaved coded modulation receiver for the DVB-T2 standard: design, implementation and FPGA proto-typing. *IEEE Workshop on Signal Processing Systems (SIPS),* October 2011
- **J. ZHANG ; M. P. C. FOSSORIER.** Shuffled Iterative Decoding. *IEEE Trans. Communications,* February 2005, vol. 53 (2
- **T. RICHARDSON ; R. UR-BANKE.** *Modern Coding Theory,* ISBN 9780521852296
- **S. TEN BRINK ; G. KRAMER ; A. ASHI-KHMIN.** Design of Low-Density Parity-Check Codes for Modulation and Detection. *IEEE Transactions on Communications,* April 2004, vol. 52 (4